# EUROPEAN PATENT APPLICATION

(11) **EP 2 725 123 A1**
(43) Date of publication of application: **30.04.2014**
(21) Application number: 11868178.2
(22) Date of filing: 23.06.2011
(51) Int. Cl.: C30B 29/38, C30B 7/10

(54) **METHOD FOR PRODUCING NITRIDE SINGLE CRYSTAL AND AUTOCLAVE USED THEREFOR**

(71) Applicant: Asahi Kasei Kabushiki Kaisha, Kita-ku, Osaka-shi Osaka 530-8205 (JP); Tohoku University, Aoba-ku Sendai-shi Miyagi 980-8577 (JP)
(72) Inventor: AOKI, Kensuke, Tokyo 101-8101 (JP); YOSHIDA, Kazuo, Tokyo 101-8101 (JP); NAKAMURA, Katsuhito, Tokyo 101-8101 (JP); FUKUDA, Tsuguo, Sendai-shi Miyagi 980-8577 (JP)
(74) Representative: von Kreisler Selting Werner
(86) International application number: PCT/JP2011/064469
(87) International publication number: WO 2012/176318

(57) **Abstract**

There is provided a novel method for producing a nitride single crystal with both a rapid crystal growth rate and high crystal quality, as well as a novel autoclave that can be used in the method. The invention provides a method for producing a Ga-containing nitride single crystal by an ammonothermal method, comprising introducing at least a starting material, an acidic mineralizer and ammonia into an autoclave, and then growing a Ga-containing nitride single crystal under conditions wherein the temperature (T1) at the single crystal growth site is 600°C to 850°C, the temperature (T1) at the single crystal growth site and the temperature (T2) at the starting material feeder site are in the relationship T1 > T2, and the pressure in the autoclave is 40 MPa to 250 MPa, as well as an autoclave that can be used in the method.

## Description

### Technical Field

The present invention relates to a method for producing a nitride single crystal by an ammonothermal method, which is a solvothermal method, and to a novel autoclave to be used in the method. More specifically, it relates to a novel production method for nitride single crystals that can yield Ga-containing nitride bulk single crystals using an acidic mineralizer in an ammonothermal method employing an ammonia solvent, and to an autoclave that can be used for the method.

### Background Art

GaN (gallium nitride) crystals are used for luminescent devices such as light emitting diodes and laser diodes. Such luminescent devices utilize crystals of nitrides of elements of Group 13 of the Periodic Table such as Al, Ga and In, and specifically Group 13 element nitrides such as AlN, GaN and InN, or mixed Group 13 element nitrides containing multiple different Group 13 elements.

A common method of producing a nitride thin-film for a luminescent device employs heteroepitaxial growth using sapphire or silicon carbide as the substrate. In this method, defects such as dislocation defects are generated in the nitride film due to the difference between the lattice constant of the sapphire substrate or silicon carbide substrate and the lattice constant of the nitride film. Such defects lower the properties of the luminescent device. If a Group 13 element nitride crystal with high purity and high quality could be obtained, it could be used as a substrate for growth of a nitride thin-film on the substrate without a lattice constant difference between it and the substrate. A high-quality Group 13 element nitride crystal can potentially increase the efficiency of luminescent devices employing Group 13 element nitride semiconductors, and allow the development of power semiconductor applications for Group 13 element nitride semiconductors.

As examples of methods for producing GaN bulk single crystals, there have been reported high-temperature, high-pressure methods, HVPE (Hydride Vapor Phase Epitaxy) methods, flux methods and sublimation methods. However, crystal growth techniques are not simple and have not been widely employed. GaN self-supporting substrates produced by HVPE methods have begun to be marketed. However, because of the problem of the high cost of such GaN self-supporting substrates, methods of detaching the GaN from the substrate used for its growth, and warping of the grown crystal, GaN self-supporting substrates obtained by HVPE methods have not yet reached a practical level.

A "solvothermal method" is a general term for methods of producing crystals using solvents in a supercritical state and/or subcritical state, and more particularly such a method is referred to as a hydrothermal method when water is used as the solvent or as an ammonothermal method when ammonia is used as the solvent. Hydrothermal methods are used as industrial production methods for artificial crystals, and are widely known as methods for obtaining high-quality crystals.

Ammonothermal methods are promising as methods for producing bulk single crystals of nitrides such as GaN. An ammonothermal method is a method in which the starting materials are dissolved or reacted using ammonia as the solvent while adjusting the temperature and pressure, and for example, the temperature dependence of the solubility is utilized for crystal growth. It is expected that high quality bulk single crystals can be industrially produced by ammonothermal methods, similar to artificial crystals obtained by hydrothermal methods.

In an ammonothermal method, it is known to be effective to add a mineralizer for production of bulk single crystals of nitrides such as GaN. A mineralizer is an additive that increases the solubility of the starting materials in supercritical ammonia and promotes crystal growth. Mineralizers are largely classified as acidic mineralizers that, when dissolved in an ammonia solvent, have the function of lowering the pH of the solvent and basic mineralizers that have a function of raising the pH of the solvent.

For example, PTL 1 discloses a method for obtaining a GaN bulk single crystal by selective crystallization on a seed crystal, by an ammonothermal method using a basic mineralizer.

When an acidic mineralizer is used, on the other hand, an autoclave having an interior lined with a precious metal such as platinum can be used to allow single crystal growth by an ammonothermal method. NPL 1 teaches that GaN crystals are obtained by an ammonothermal method at a pressure of about 200 MPa using the acidic mineralizer NH₄Cl and an autoclave lined with platinum.

PTL 2 describes an ammonothermal method using an acidic mineralizer. In the method described in PTL 2, the autoclave used comprises a lower starting material filling section and an upper crystal growth section, partitioned by a baffle plate. A starting material composed mainly of nitride polycrystals is filled into the lower section, and a seed crystal is situated in the upper section. By maintaining a lower temperature in the upper section than in the lower section, a seed crystal is grown in the low-temperature range of the upper section.

The preferred crystal growth conditions are known to differ significantly depending on whether an acidic mineralizer is used or a basic mineralizer is used. For example, it is known that when a basic mineralizer is to be used in an ammonothermal method it is necessary to have a relatively high pressure of about 150-500 MPa, whereas when an acidic mineralizer is used, a relatively low pressure of about 100-200 MPa can be employed. The corrosion resistance required for the autoclave also differs depending on whether an acidic mineralizer or a basic mineralizer is used. Thus, the production conditions for a single crystal differ significantly depending on whether the mineralizer used is acidic or basic in nitride single crystal production by an ammonothermal method.

When an acidic mineralizer is used for growth of a nitride single crystal on a seed crystal by an ammonothermal method in the prior art, as described in PTL 3, the starting polycrystals are placed in the lower section of the autoclave while the seed crystal is placed in the upper section of the autoclave. When a basic mineralizer is used, however, the placement is in reverse. These placement conditions have been considered to be the common growth conditions for nitride single crystals by ammonothermal methods in the prior art.

Research has also been conducted on methods that do not use seed crystals, such as methods wherein microcrystals obtained by spontaneous nucleation by ammonothermal methods are used as starting materials for continuously conducted crystal growth (see PTL 4, for example).

### Citation List

### Patent Literature

[PTL 1] Japanese Patent Public Inspection No. 2004-533391
[PTL 2] Japanese Unexamined Patent Publication No. 2008-120672
[PTL 3] U.S. Patent Application Publication No. 20100303704
[PTL 4] Japanese Unexamined Patent Publication No. 2008-143778

### [Non-patent literature]

[NPL 1] X.L. Chenm, Y.G. Cao, Y.C. Lan, X.P. Xu, J.Q. Lu, P.Z. Jiang, T. Xu, Z.G. Bai, Y.D. Yu, J.K. Liang, "Journal of Crystal Growth", Vol.209, 2000, p.208-212

### DISCLOSURE OF THE INVENTION

### Problems to be Solved by the Invention

However, microcrystals obtained by spontaneous nucleation are in the form of powders with sizes of a few microns, and therefore they cannot be used as seed crystals. Thus, it has not been possible in the past to obtain seed crystals to be used in ammonothermal methods, by spontaneous nucleation using ammonothermal methods.

Despite much research on this issue, nitride single crystal growth techniques by ammonothermal methods are still not fully developed. In order to develop nitride single crystal growth techniques by ammonothermal methods for industrial use, it is necessary to achieve both high growth rates for increased productivity, and higher crystal quality, and therefore many issues currently remain to be resolved.

In the case of gallium nitride, for example, with the nitride single crystal growth techniques by ammonothermal methods that have been reported in the past, the growth rates have been from 30 µm/day to a few microns per day, which is slow compared to the competing HVPE methods and flux methods. In the prior art it has been difficult to achieve both high growth rate and smooth surface growth.

It is therefore an object of the present invention to provide a novel method for producing a nitride single crystal that can achieve both a rapid crystal growth rate and high crystal quality by an ammonothermal method, as well as a novel autoclave that can be used in the method. It is another object of the invention to provide a precious metal-lined autoclave that can maintain pressure even with repeated use, without detachment, cracking or wear of the precious metal lining.

### Means for Solving the Problems

As a result of much experimentation directed toward solving the problems mentioned above, the present inventors have found that it is possible to achieve both a rapid crystal growth rate and high crystal quality if in an ammonothermal method using an acidic mineralizer, a higher crystal growth temperature is employed than in the prior art, and the relationship between the temperatures and positions of the starting material placement site and the crystal growth site in the autoclave are different from common prior art methods using acidic mineralizers. In other words, the temperature (T1) at the single crystal growth site is set to be higher than the temperature (T2) at the starting material feeder site (T1>T2), from 600°C to 850°C which is a higher crystal growth temperature range than the prior art. Also, in the autoclave, the material of the shield section, which is the section that bonds two or more parts composing the autoclave to maintain the pressure, is made of an alloy of iridium and platinum or iridium alone, the proportion of iridium among the entire constituent elements of the material of the shield section being 20 mass% to 100 mass%. It was found that this gives the shield section satisfactory hardness and can increase the frequency of repeated use of the precious metal-lined autoclave. Specifically, the present invention provides the following.

[1] A method for producing a Ga-containing nitride single crystal by an ammonothermal method from a starting material containing at least one material selected from the group consisting of Ga-containing nitride polycrystals, Ga-containing nitrides and Ga-containing nitride precursors, the method comprising:
   introducing at least the starting material, one or more acidic mineralizers and ammonia into an autoclave, and then growing a Ga-containing nitride single crystal under conditions satisfying the following (a) to (e):
      (a) the autoclave includes a starting material feeder site in which the starting material is placed and a single crystal growth site for growth of the Ga-containing nitride single crystal,
      (b) the single crystal growth site is the site in which a seed crystal is placed,
      (c) the temperature (T1) at the single crystal growth site is 600°C to 850°C,
      (d) the temperature (T1) at the single crystal growth site and the temperature (T2) at the starting material feeder site are in the relationship T1 > T2, and
      (e) the pressure in the autoclave is 40 MPa to 250 MPa.
[2] A method for producing a Ga-containing nitride single crystal by an ammonothermal method from a starting material containing at least one material selected from the group consisting of Ga-containing nitride polycrystals, Ga-containing nitrides and Ga-containing nitride precursors, the method comprising:
   introducing at least the starting material, one or more acidic mineralizers and ammonia into an autoclave, and then growing a Ga-containing nitride single crystal under conditions satisfying the following (a) to (e):
      (a) the autoclave includes a starting material feeder site in which the starting material is placed and a single crystal growth site for growth of the Ga-containing nitride single crystal,
      (b) the single crystal growth site is the site in which a Ga-containing nitride single crystal deposits and grows by spontaneous nucleation,
      (c) the temperature (T1) at the single crystal growth site is 600°C to 850°C,
      (d) the temperature (T1) at the single crystal growth site and the temperature (T2) at the starting material feeder site are in the relationship T1 > T2, and
      (e) the pressure in the autoclave is 40 MPa to 250 MPa.
[3] The method for producing a nitride single crystal according to [1] above, wherein the seed crystal is a Ga-containing nitride single crystal produced by the method for producing a nitride single crystal according to [2] above.
[4] The method for producing a nitride single crystal according to any one of [1] to [3] above, wherein:
   the starting material is placed in a container having a plurality of holes or slit-like gaps formed therein, and
   gaps of 1 mm or greater are present between the sides of the container and the inner wall of the autoclave.
[5] The method for producing a nitride single crystal according to any one of [1] to [4] above, wherein the autoclave is a vertical autoclave, and the starting material feeder site is at a higher position than the single crystal growth site.
[6] The method for producing a nitride single crystal according to [5] above, wherein:
   the starting material feeder site is at a position at a height of at least 10 mm from the interior bottom of the autoclave, and
   the single crystal growth site is present between the starting material feeder site and the interior bottom of the autoclave.
[7] The method for producing a nitride single crystal according to any one of [1] to [6] above, wherein at least one partition plate is placed between the starting material feeder site and the single crystal growth site.
[8] The method for producing a nitride single crystal according to any one of [2] and [4] to [7] above, wherein:
   the single crystal growth site is the site where a Ga-containing nitride single crystal deposits and grows by spontaneous nucleation, and
   a corrosion-resistant plate with at least one hole is placed in the single crystal growth site.
[9] The method for producing a nitride single crystal according to any one of [1] to [8] above, wherein the starting material contains Ga-containing nitride polycrystals produced by a gas phase method.
[10] A substrate made of a nitride single crystal produced by the method for producing a nitride single crystal according to any one of [1] to [9] above.
[11] A nitride single crystal produced by the method for producing a nitride single crystal according to any one of [1] to [9] above and having a maximum dimension of 1 mm or greater.
[12] An autoclave to be used for a method for producing a nitride single crystal according to any one of [1] to [9] above, wherein:
   the material of the shield section, which is the section that bonds two or more parts composing the autoclave to maintain the pressure in the autoclave, is made of an alloy of iridium and platinum or iridium alone, and
   the proportion of iridium among the entire constituent elements of the material of the shield section is 20 mass% to 100 mass%.

### Effect of the Invention

By the method for producing a nitride single crystal according to the invention it is possible to accomplish growth of a nitride single crystal with excellent crystal quality at a faster crystal growth rate than the prior art (for example, 30 µm/day or higher). In addition, since a nitride single crystal obtained by the production method of the invention has a flat membrane-like growth layer, it can be obtained as a bulk nitride single crystal allowing cutting out of substrates with various crystal orientations.

Also, the method for producing a nitride single crystal according to the invention can easily yield a single crystal of manageable size by spontaneous nucleation. Since the obtained single crystal grain has a size with a maximum dimension of 1 mm or greater, for example, it can be utilized as a seed crystal.

Furthermore, the material of the shield section in the autoclave of the invention is composed of an alloy of iridium and platinum or of iridium alone, and the proportion of iridium among the entire constituent elements of the material is 20 mass% to 100 mass%. By constructing the shield section in this manner the hardness of the shield section is drastically increased, and therefore the shield section is resistant to wear and damage even if force is applied to the shield section, and the autoclave can be repeatedly used even under high-temperature conditions of 600°C to 850°C which are expected for the method of the invention. Specifically, if an alloy of iridium and platinum or iridium alone is used as the material for the shield section, there will be no melting and bonding of the shield section at temperatures of up to 850°C, and therefore the shield material will not detach or break when the cover of the autoclave has been opened. Consequently, the autoclave of the invention can maintain its pressure even when repeatedly used under high-temperature conditions of 600°C to 850°C.

### Brief Description of the Drawings

Fig. 1 is a diagram showing a mode of the invention in which a single crystal is grown using a seed crystal in a vertical autoclave.
Fig. 2 is a diagram showing a mode of the invention in which a single crystal is grown by spontaneous nucleation in a vertical autoclave.
Fig. 3 is a simplified cross-sectional view of an autoclave according to the invention.
Fig. 4 is a simplified cross-sectional view of the shield section of an autoclave according to the invention.
Fig. 5 is a schematic diagram showing an example of upper tubing connected to an autoclave according to the invention.
Fig. 6 is an optical microscope photograph of a crystal grain of the same size as the seed crystal used in Example 1 (top), and a nitride single crystal obtained by growth in Example 1 (bottom).
Fig. 7 is a diagram showing an X-ray diffraction pattern (XRD pattern) for the GaN single crystal obtained in Example 8.
Fig. 8 is an optical microscope photograph of the GaN single crystal obtained in Example 8.
Fig. 9 is an optical microscope photograph of the GaN single crystal obtained in Example 13.
Fig. 10 is a diagram showing an X-ray diffraction pattern (XRD pattern) for the GaN single crystal obtained in Example 13.

### Best Mode for Carrying Out the Invention

More specific modes of the invention will now be explained in detail. The explanation that follows is based on representative working modes of the invention, with the understanding that the invention is not limited to these working modes.

### <Method for producing nitride single crystal>

According to one aspect of the invention there is provided a method for producing a Ga-containing nitride single crystal by an ammonothermal method from a starting material containing at least one material selected from the group consisting of Ga-containing nitride polycrystals, Ga-containing nitrides and Ga-containing nitride precursors, the method comprising:
introducing at least the starting material, one or more acidic mineralizers and ammonia into an autoclave, and then growing a Ga-containing nitride single crystal under conditions satisfying the following (a) to (e):
   (a) the autoclave includes a starting material feeder site in which the starting material is placed and a single crystal growth site for growth of the Ga-containing nitride single crystal,
   (b) the single crystal growth site is the site in which a seed crystal is placed,
   (c) the temperature (T1) at the single crystal growth site is 600°C to 850°C,
   (d) the temperature (T1) at the single crystal growth site and the temperature (T2) at the starting material feeder site are in the relationship T1 > T2, and
   (e) the pressure in the autoclave is 40 MPa to 250 MPa.

According to another aspect of the invention there is provided a method for producing a Ga-containing nitride single crystal by an ammonothermal method from a starting material containing at least one material selected from the group consisting of Ga-containing nitride polycrystals, Ga-containing nitrides and Ga-containing nitride precursors, the method comprising:
introducing at least the starting material, one or more acidic mineralizers and ammonia into an autoclave, and then growing a Ga-containing nitride single crystal under conditions satisfying the following (a) to (e):
   (a) the autoclave includes a starting material feeder site in which the starting material is placed and a single crystal growth site for growth of the Ga-containing nitride single crystal,
   (b) the single crystal growth site is the site in which a Ga-containing nitride single crystal deposits and grows by spontaneous nucleation,
   (c) the temperature (T1) at the single crystal growth site is 600°C to 850°C,
   (d) the temperature (T1) at the single crystal growth site and the temperature (T2) at the starting material feeder site are in the relationship T1 > T2, and
   (e) the pressure in the autoclave is 40 MPa to 250 MPa.

Throughout the present specification, the term "Ga-containing nitride" includes GaN (gallium nitride), and nitrides containing Ga and other elements (typically elements of Group 13 of the Periodic Table (IUPAC, 1989), hereunder also referred to as "Group 13 elements"). In other words, the Ga-containing nitride for the purpose of the invention includes not only nitrides of the single metal such as GaN, but also multielement compounds such as AlGaN, InGaN and AlInGaN. These chemical formulas merely denote the constituent elements of the nitrides and not their compositional ratios.

The Ga-containing nitride single crystal to be produced according to the invention may be GaN; a mixed crystal of GaN with another Group 13 element nitride; or a multielement nitride containing Ga and another Group 13 element. Multielement nitrides include AlGaN, InGaN and AlInGaN. Mixed crystals include Group 13 element nitride mixed crystals containing BN, AlN, GaN and InN.

According to the invention, a polycrystal is a solid obtained in different apparent forms such as masses, grains and powders, wherein a plurality of fine single crystals, i.e. microcrystals are present in an inseparable form oriented in mutually different directions. There is no particular restriction on the sizes of the microcrystals or on the alignments of the orientations of the microcrystals, i.e. on the degree of orientation.

According to the invention, a starting material is used that contains at least one selected from the group consisting of Ga-containing nitride polycrystals, Ga-containing nitrides and Ga-containing nitride precursors. The starting material will typically contain Ga-containing nitride polycrystals, and more typically consists of Ga-containing nitride polycrystals. However, the starting material does not necessarily need to be composed entirely of a complete nitride, and it may also contain zerovalent metals, for example.

The nitride polycrystals and nitride single crystals referred to throughout the present specification may further contain trace amounts of magnesium, zinc, carbon, silicon, germanium or the like as doping materials, in ranges of 1/10 to 1/1,000,000 with respect to the number of moles of Group 13 elements.

The Ga-containing nitride may be supplied as starting material in the form of polycrystals or non-polycrystals. Examples of Ga-containing nitrides include GaN as a simple element nitride, and AlGaN as a multielement nitride. The starting material may also be a mixture. For example, a mixture of a Ga-containing nitride and a Ga-non-containing nitride may be used, a preferred example being a mixture of GaN with one or more selected from the group consisting of BN, AlN and InN. A mixture of AlN and GaN is a more typical preferred example.

Examples of Ga-containing nitride precursors include gallium azide, gallium imide, gallium amideimide, gallium hydride, gallium-containing alloys and metallic gallium. The starting material may also be a mixture. For example, a Ga-containing nitride precursor may be used in a mixture with aluminum amide, aluminum imide, potassium imide, indium amide, indium imide or the like. These form nitrides in supercritical ammonia and can form single crystals.

Each compound used in the starting material is preferably of high purity. On the other hand, the starting material dissolves in the ammonia solvent during use and therefore does not need to have high crystallinity.

There are no particular restrictions on the method for producing the nitride polycrystals to be used as the starting material. However, from the viewpoint of reducing impurities in the starting material, the starting material preferably contains Ga-containing nitride polycrystals produced by a gas phase method. More preferably, the starting material is composed of Ga-containing nitride polycrystals produced by a gas phase method. Using GaN as an example, nitride polycrystals may be produced by a method of nitriding metallic gallium or Ga₂O₃ with ammonia. Alternatively, nitride polycrystals can be obtained by reaction between a halide and ammonia as in the HVPE method.

Ammonia is used as the solvent according to the invention, and preferably the amount of impurities in the ammonia is as low as possible. The purity of the ammonia used is usually 99.9 mass% or greater, preferably 99.99 mass% or greater and more preferably 99.999 mass% or greater.

The method of the invention produces a Ga-containing nitride single crystal by an ammonothermal method (i.e. a supercritical crystallization method) in an autoclave in the presence of ammonia, and more specifically in an ammonia atmosphere. An ammonothermal method is a method as described in PTL 1 or NPL 1 mentioned above.

The crystal growth time will typically be from 1 day to 1 year, and is more preferably between 2 days and 6 months.

The ammonia forms an ammonia atmosphere during the reaction and functions as a solvent. The ammonia atmosphere can be formed by pure ammonia and/or nitrogen and hydrogen produced by thermal decomposition of ammonia, and it further contains an acidic mineralizer.

The acidic mineralizer to be added to the ammonia solvent may be a compound containing a halogen element, such as an ammonium halide. Ammonium halides include ammonium chloride, ammonium iodide, ammonium bromide and ammonium fluoride, ammonium chloride being especially preferred from the viewpoint of availability as a starting material and ease of handleability.

The proportion of mineralizer used is preferably in the range of 0.0001 to 0.2 as the molar ratio of mineralizer/ammonia. A molar ratio of 0.0001 or greater is advantageous from the viewpoint of increasing starting material solubility and increasing the growth rate, and a ratio of no greater than 0.2 is advantageous from the viewpoint of lowering the level of impurities. The molar ratio of mineralizer/ammonia is more preferably in the range of 0.001 to 0.1 and even more preferably in the range of 0.005 to 0.05.

The ammonia filling volume is adjusted so that the pressure in the autoclave used is between 40 MPa and 250 MPa at the selected temperature. If the ammonia filling volume is increased it is possible to increase the speed of single crystal growth, but when the pressure exceeds the upper limit of this range the valve of the autoclave is operated to discharge a portion of the ammonia to avoid exceeding the pressure range.

The pressure in the autoclave during single crystal growth is preferably high from the viewpoint of increasing the single crystal growth rate. In an ammonothermal method the pressure in the autoclave is usually 20 MPa to 500 MPa, but from the viewpoint of obtaining a high single crystal growth rate, it is preferably 30 MPa or higher, more preferably 40 MPa or higher, even more preferably 50 MPa or higher, yet more preferably 60 MPa or higher and most preferably 70 MPa or higher. Considering load on the autoclave that is used and production efficiency for large-volume autoclaves, the pressure in the autoclave is preferably no greater than 250 MPa, more preferably no greater than 200 MPa, even more preferably no greater than 150 MPa and most preferably no greater than 130 MPa.

The pressure in the autoclave used for the invention is in the range of 40 MPa to 250 MPa within the specific temperature range for the single crystal growth site designated according to the invention, from the viewpoint of increasing the single crystal growth rate, reducing load on the autoclave and obtaining satisfactory production efficiency. The pressure in the autoclave is preferably 40 MPa to 200 MPa, more preferably 50 MPa to 180 MPa and even more preferably 60 MPa to 150 MPa.

The starting material may be in any desired form such as a mass, granules or powder. The starting material is preferably placed in a container provided with a plurality of holes or slit-like gaps. The container provided with a plurality of holes may be a basket-like container formed of a mesh, for example. By using the aforementioned container it is possible to place the starting material at a desired location inside the autoclave. The holes or slit-like gaps of the container may be selected according to the form of the starting material that will be used, as a size suitable for the holes or slits and the fineness of the mesh. Preferably, the starting material placed in the container contacts efficiently with the ammonia solvent and rapidly dissolves.

In the method for producing a nitride single crystal according to the invention using an ammonothermal method, it is important to efficiently dissolve the starting material in supercritical ammonia. Consequently, it is preferred for a gap of at least 1 mm to be present between the sides of the container holding the starting material (most typically a container as described above provided with a plurality of hole or slit-like gaps) and the inner wall of the autoclave, so that the flow of the supercritical ammonia solvent does not pool in the interior of the autoclave that is used.

According to the invention, the temperature (T1) at the single crystal growth site is 600°C or higher, preferably 630°C or higher, more preferably 650°C or higher, even more preferably 670°C or higher and most preferably 690°C or higher, from the viewpoint of ensuring a sufficient crystal growth rate. On the other hand, the temperature of the single crystal growth site is no higher than 850°C, preferably no higher than 800°C and more preferably no higher than 750°C from the viewpoint of the durability of the autoclave.

The temperature of the ammonia atmosphere is preferably 600°C or higher in the method for producing a nitride single crystal according to the invention, as this will tend to increase the crystal growth rate. Up to near 750°C, a higher temperature will have a greater tendency to result in a higher crystal growth rate, whereas such a tendency is reduced at temperatures higher than about 750°C. Consequently, crystal growth occurs even if the temperature of the ammonia atmosphere is increased to 850°C, but in consideration of the durability of the autoclave, the temperature of the ammonia atmosphere is preferably no higher than 800°C, and more preferably no higher than 750°C.

According to the invention, the temperature (T1) at the crystal growth site is set to be higher than the temperature (T2) at the starting material feeder site. That is, the temperatures satisfy the relationship T1 > T2. The temperatures T1 and T2 are the mean temperatures for the entire crystal growth time. The temperature (T1) at the single crystal growth site is that at the site where the seed crystal was placed (when a seed crystal is used), or the site where the nitride single crystal deposits and grows by spontaneous nucleation (when a seed crystal is not used). For example, the temperature difference (T1-T2) between the temperature (T1) at the single crystal growth site and the temperature (T2) at the starting material feeder site may be 1°C to 150°C. If the temperature difference is increased, the crystal growth rate can be increased. If the temperature difference is reduced, on the other hand, the quality of the single crystal tends to be improved. Thus, from the viewpoint of the single crystal growth rate (i.e. the single crystal deposition rate) and the single crystal quality, the temperature difference (T1-T2) is preferably 5°C to 100°C and more preferably 10°C to 90°C.

According to the invention, the single crystal growth site may overlap with the starting material feeder site, so long as the aforementioned temperature conditions are satisfied. For example, if the seed crystal is placed in a mesh-like container together with the starting material while maintaining a space on the surface allowing growth of the single crystal, this will allow growth of a nitride single crystal at a location very near the location in which the starting material has been placed, allowing a high crystal growth rate to be achieved.

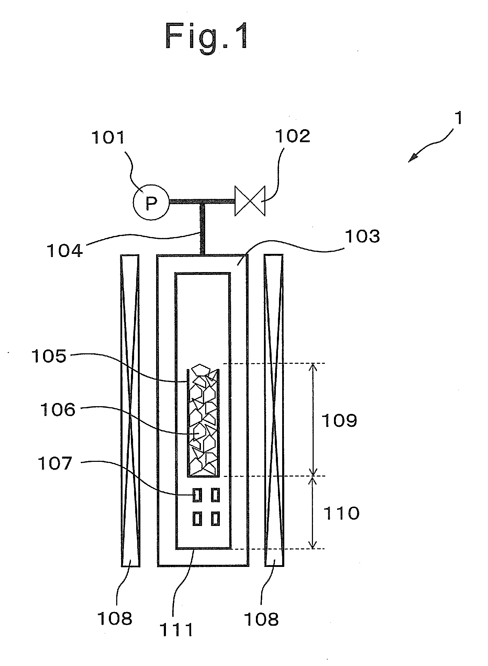

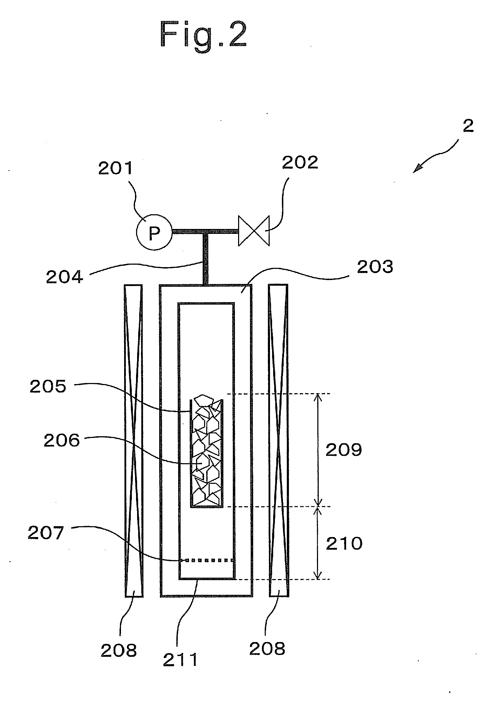

According to the invention, a vertical autoclave may be used. Fig. 1 is a diagram showing a mode of the invention in which a single crystal is grown using a seed crystal in a vertical autoclave. Fig. 2 is a diagram showing a mode of the invention in which a single crystal is grown by spontaneous nucleation in a vertical autoclave. In each of the vertical autoclaves 1 and 2, a pressure gauge 101, 201 and valve 102, 202 are connected to the main body 103, 203 through a conduit 104, 204. In the main body 103, 203 there are provided a starting material feeder site 109, 209, in which the starting material 106, 206 housed in the starting material container 105, 205 is placed, and a single crystal growth site 110, 210. The main body 103, 203 is heated by a heater 108, 208. In the autoclave shown in Fig. 1, a seed crystal 107 is placed in the single crystal growth site 110. In the autoclave shown in Fig. 2, on the other hand, a single crystal growth site 210 is provided for depositing and growth of a Ga-containing nitride single crystal by spontaneous nucleation, and a plate 207 is placed therein. The plate 207 is a corrosion resistant plate with one or more holes, consisting of a mesh material, for example.

When a vertical autoclave is used, the starting material feeder site 109, 209 is preferably located at a higher position than the single crystal growth site 110, 210 (i.e. a high location in the vertical direction), as shown in Fig. 1 and Fig. 2. This will allow more efficient deposition of a single crystal. Such a positional relationship can provide a single crystal growth site 110, 210 between the starting material feeder site 109, 209 and the interior bottom 111, 211 of the autoclave. In this case, the starting material falls into the single crystal growth site 110, 210 from the starting material feeder site 109, 209 by gravity, easily producing a convection current. Also, this allows efficient growth of a single crystal at the single crystal growth site, based on the seed crystal 107 placed in the single crystal growth site 110, or the single crystal produced by spontaneous nucleation in the single crystal growth site 210.

A crystal growth method using a vertical autoclave allows crystal growth to be efficiently accomplished by the aforementioned convection current effect. Even if a vertical autoclave is not used, however, or if a vertical autoclave is used but the starting material feeder site is situated at a location lower than the single crystal growth site, it is still possible to produce a single crystal so long as this convection current phenomenon is produced.

According to the invention, the starting material feeder site is preferably provided at a location at a height of at least 10 mm from the interior bottom of the autoclave (that is, the shortest distance between the interior bottom of the autoclave and the starting material feeder site is at least 10 mm), while the single crystal growth site is situated between the starting material feeder site and the interior bottom of the autoclave. This can effectively prevent polycrystallization due to formation of masses between the deposited single crystal and other single crystal grains. The height from the interior bottom of the autoclave to the starting material feeder site (that is, the shortest distance between the interior bottom of the autoclave and the starting material feeder site) may be 50 mm, for example. In order to provide the single crystal growth site and starting material feeder site in the vertical autoclave, the sum of the volumes occupied by the single crystal growth site and the starting material feeder site must not exceed the entire space volume in the autoclave, although the proportion may be determined as desired. From the standpoint of productivity, it is preferred to increase the size of the single crystal growth site to allow the maximum number of seed crystals to be placed or to allow spontaneous nucleation in the widest region possible, but it is also preferred to increase the size of the starting material feeder site since a greater amount of starting material will be required. If the height from the interior bottom of the autoclave to the starting material feeder site is at least 10 mm, this space may be used as the single crystal growth site to allow effective single crystal growth in the space. For a vertical autoclave with an inner length of 250 mm this corresponds to 4 vol% of the entire space in the autoclave. On the other hand, the volume of the single crystal growth site occupying the entire space in the autoclave will be limited by the size of the starting material feeder site, the upper limit typically being 70 vol%, for the reason explained above. It is preferably 10 to 60 vol% and even more preferably 20 to 40 vol%.

The important features of the present invention are that an acidic mineralizer is used, the temperature (T1) at the single crystal growth site is 600°C to 850°C, and the temperature (T1) at the crystal growth site is higher than the temperature (T2) at the starting material feeder site. According to one mode of the invention, the starting material feeder site is situated at the top of the autoclave and the single crystal growth site at the bottom, allowing single crystal growth. In a mode using an acidic mineralizer with ordinary placement according to the prior art (in other words, a mode with a polycrystal starting material placed at the bottom of the autoclave and a seed crystal placed at the top, the temperature of the polycrystal starting material being higher than the temperature of the seed crystal), it is not possible to satisfactorily accomplish growth of a nitride single crystal in the temperature range of the single crystal growth site disclosed by the present invention, i.e. 600°C to 850°C. An autoclave suitable for carrying out the method of the invention may be an autoclave wherein the material of the shield section, which is the section that bonds two or more parts composing the autoclave to maintain the pressure in the autoclave, is an alloy of iridium and platinum or iridium alone, and the proportion of iridium among the entire constituent elements of the material of the shield section is 20 mass% to 100 mass%. A typical type of such an autoclave will be further explained below under

### <Autoclave>.

The seed crystal to be used in one mode of the invention is preferably a material having parameters such as crystal system, lattice constant and crystal lattice size that are matching or compatible with the desired nitride single crystal. For example, if the Ga-containing nitride single crystal to be produced according to the invention is a GaN single crystal, a nitride single crystal of aluminum nitride or the like, then a single crystal of zinc oxide, or a single crystal of silicon carbide may be utilized. More preferably, a gallium nitride single crystal is used. The method for producing the seed crystal is not particularly restricted, and in the case of gallium nitride, for example, there may be employed a single crystal substrate or template substrate formed by MOCVD or HVPE, a self-supporting substrate obtained by a high-pressure method, or a self-supporting GaN crystal produced by a flux method. The nitride single crystal grain obtained by spontaneous nucleation in an ammonothermal method may be used directly, or it may be cut for use. When the single crystal obtained by spontaneous nucleation has a particle size of 1 mm or greater, it can be used as the seed crystal. Thus, it is possible to produce a crystal grain with a size of 1 mm or greater by spontaneous nucleation without using a seed crystal, as disclosed by the present invention, and the crystal grain utilized as a seed crystal. The crystal grain produced by spontaneous nucleation has high crystal quality, and therefore when used as a seed crystal it can yield a single crystal of high quality.

In order to obtain a nitride single crystal of high quality in a mode of the invention based on spontaneous nucleation, it is preferred to minimize polycrystallization of the deposited single crystal grain by formation of a mass with other single crystal grains. A crystal grain that has fallen to the bottom of the autoclave tends to form a mass and undergo polycrystallization. Thus, it is effective to selectively entrap single crystal grains that reach a certain size and fall down, and to promote growth of a single crystal at the location of entrapment. It is therefore preferred to place a corrosion resistant plate with one or more holes (for example, the plate 207 shown in Fig. 2) in the single crystal growth site. The plate may be composed of a mesh material or the like. Placing such a plate will promote growth of larger single crystals from single crystal grains trapped on the plate.

The single crystal grain may also be utilized as a seed crystal for a mode of the invention that uses a seed crystal. In this case, a single crystal grain is produced by spontaneous nucleation in the mode shown in Fig. 2, for example, and is used as the seed crystal 107 shown in Fig. 1, for example.

According to the invention, it is preferred to place at least one partition plate as a baffle between the starting material feeder site and the single crystal growth site, in order to appropriately limit the convection current and keep the respective environments of the starting material feeder site and the single crystal growth site in the preferred states.

The method for producing a nitride single crystal according to the invention is as described above. The invention relates to a method for producing a Ga-containing nitride single crystal. The effect obtained by the method disclosed by the present invention, i.e. the effect of achieving a fast crystal growth rate and excellent crystal quality for obtained single crystals, is especially notable for Ga-containing nitride single crystals. However, the production method of the invention can obviously be applied for production of Group 13 element nitride single crystals containing no Ga, instead of Ga-containing nitrides. Group 13 elements include, in addition to Ga, also B, Al, In and the like. Group 13 element nitride crystals include, in addition to GaN, also BN, AlN, InN and the like.

### <Substrate>

According to another aspect of the invention there is provided a substrate made of a nitride single crystal, produced by the method of the invention described above. A substrate provided by the invention has excellent crystal quality and can be suitably applied for luminescent devices such as light emitting diodes and laser diodes.

### <Nitride single crystal>

According to yet another aspect of the invention there is provided a nitride single crystal produced by the method of the invention described above, and having a maximum dimension of 1 mm or greater. Specific examples of nitride single crystals are as mentioned above, and include GaN; mixed crystals of GaN with other Group 13 element nitrides; and multielement nitrides containing Ga and other Group 13 elements. A nitride single crystal with a maximum dimension of 1 mm or greater can be suitably applied for luminescent devices such as light emitting diodes and laser diodes.

### <Autoclave>

Another aspect of the invention provides an autoclave to be used for a method for producing a nitride single crystal according to the invention described above, wherein:
the material of the shield section, which is the section that bonds two or more parts composing the autoclave to maintain the pressure in the autoclave, is made of an alloy of iridium and platinum or iridium alone, and
the proportion of iridium among the entire constituent elements of the material of the shield section is 20 mass% to 100 mass%.

The present inventors have investigated methods of producing Group 13 element nitrogen compounds such as GaN and AlN that are promising as materials for compound semiconductor substrates, by ammonothermal methods that are considered suitable for industrial production. The present inventors have also investigated the durability of precious metal-lined autoclaves under repeated use. It has been found that autoclaves having the construction described in detail below can be suitably applied to the method for producing a nitride single crystal according to the invention described above. It was found that the autoclave provided by the invention can be satisfactorily applied to an ammonothermal method using an acidic mineralizer according to the invention, as well as to an ammonothermal method using a basic mineralizer or an essentially neutral mineralizer. A typical mode of an autoclave provided by the invention will now be described.

For conventional production of a semiconductor substrate in an autoclave using a Group 13 element nitride such as GaN or AlN, it is common to use an autoclave lined with a precious metal such as platinum, in order to prevent elution of iron, nickel, chromium, cobalt, molybdenum, titanium, aluminum and the like from the structural material of the autoclave. However, precious metals such as platinum are relatively soft materials, and the main body of the autoclave and the shield section of the cover sections are prone to wear. The "shield section" is the section that maintains the pressure inside the autoclave, by bonding of two or more sections composing the autoclave. That is, the ammonia solvent contacts with the shield section. With repeated use of the autoclave, the solvent leaks from the worn sections of the shield section making it impossible to maintain the pressure, and therefore repeated use is no longer possible. In addition, when a precious metal such as platinum is directly used in the shield section and a high temperature of 500°C or higher is sustained, the shield section becomes stuck making it impossible to open the cover. When the shield section becomes stuck and the cover is forced open, the shield section can become damaged making the autoclave unusable.

The present inventors have conducted much investigation of precious metal-lined autoclaves that can be repeatedly used in ammonothermal methods. As a result, it has been found that an alloy of iridium and platinum or iridium alone is suitable as a shield section material that does not result in sticking or detachment due to corrosion, wear and melting, in an acidic mineralizer-containing ammonia atmosphere at a temperature of 400°C to 850°C and a pressure of 40 MPa to 250 MPa.

Superior materials for the autoclave lining to be used in an ammonothermal method are platinum, iridium, tungsten and rhenium, from the viewpoint of preventing corrosion by ammonia. On the other hand, platinum is superior from the viewpoint of workability, allowing lining by binding to the inner side of the autoclave and following the inside structure of the autoclave. However, the following problems are associated with platinum linings.

The shield section of an autoclave is constructed with the cover pressed against the autoclave main body for shielding so that ammonia does not leak out under high pressure. Therefore, with a low-hardness material such as platinum, wear and damage occur making repeated use of the autoclave impossible. This is thought to be due to the fact that the hardness of platinum is about a Vickers hardness of 40, which is softer than the metal materials composing the autoclave.

According to the invention, the material of the shield section of the autoclave is an alloy of iridium and platinum or iridium alone, the proportion of iridium among the entire constituent elements of the material being between 20 mass% and 100 mass%. The Vickers hardness of iridium is about 220, which is more than 5 times that of platinum. With an alloy of iridium and platinum, reducing the content ratio of iridium tends to lower the hardness. However, even an alloy in which the iridium content ratio is 20 mass% has a Vickers hardness of about 120, and therefore it is a much harder material than platinum alone. Consequently, an alloy of iridium and platinum or iridium alone is notably advantageous over platinum, for realizing an autoclave having a shield section that is resistant to damage such as wear and is highly durable for repeated use.

If the iridium content ratio is 20 mass% or higher, the material hardness will be significantly higher than platinum and resistance to wear and heat-induced fusion will be exhibited. A higher iridium content ratio will tend to result in increased hardness and greater resistance to wear and heat-induced fusion. Using a shield section material with an iridium content in the range specified above according to the invention can provide highly satisfactory autoclave durability with repeated use of the autoclave in production of a Ga-containing nitride single crystal by an ammonothermal method. The iridium content ratio of the shield section material is preferably 40 mass% to 100 mass% and more preferably 60 mass% to 100 mass%.

The composition of the shield section material and the lining material other than the shield section can be quantified by X-Ray Fluorescence Analysis (XRF), for example. As a more highly accurate method, for example, the material may be dissolved in aqua regia and used in Inductively Coupled Plasma-Atomic Emission Spectrometry (ICP-AES), or the composition of the material may be directly determined during the separation and purification steps.

In a conventional autoclave using a platinum shield material, a cover section, for example, is pressed against the main body at the shield section to achieve a seal. Thus, at high temperatures of 500°C or higher, the shield section melts and undergoes adhesion (fusion), so that the platinum shield material detaches or breaks when the cover is opened, making repeated use impossible. In the autoclave of the invention, however, the shield section is made of an alloy of iridium and platinum or iridium alone, thereby significantly increasing the hardness of the shield section above that of a conventional shield section. Thus, no wear or damage is produced even when pressure is applied to the shield section, and the autoclave can be repeatedly used.

Also, when an alloy of iridium and platinum or iridium alone is used as the material for the shield section, the shield section does not melt and undergo adhesion (fusion) at temperatures of up to 850°C, and the shield material does not detach or break even when the cover is opened, so that repeated use is possible.

The autoclave of the invention is selected from among those that can withstand the high-temperature, high-pressure conditions during crystal growth. The autoclave of the invention is made of a material that is pressure resistant and erosion resistant. Ni-based alloys are materials with pressure resistance and erosion resistance, and those with excellent strength properties at high temperature are preferred. Particularly preferred are Inconel625 (Inconel is a registered trademark of The International Nickel Company, Inc.), Rene 41 (Rene is a registered trademark of Alvac Metals Company) and Udimet520 (Udimet is a registered trademark of Special Metals, Inc.).

In order to improve the erosion resistance of the autoclave, the sections of the inner surface of the autoclave that contact with ammonia, other than the shield section, are preferably lined or coated with a precious metal. In an ammonothermal method using an acidic mineralizer, single crystal growth is facilitated even at low pressure, compared to using a basic mineralizer which is typically an alkali metal amide or the like. Also, since acidic mineralizers have low corrosion on precious metals such as platinum, they allow the effects of impurities attributable to the autoclave to be reduced to an absolute minimum when the inner side of an autoclave is lined with a precious metal. Precious metals include platinum (Pt), gold (Au), iridium (Ir), ruthenium (Ru), rhodium (Rh), palladium (Pd), rhenium (Re), silver (Ag) and alloys composed mainly of these elements. Of these, platinum, iridium and their alloys are preferred from the viewpoint of excellent erosion resistance. Platinum, in particular, is relatively soft and can follow the shape of the inside of the autoclave, thus being especially suitable as a lining material. When an alloy of iridium and platinum or iridium alone is used as the material for the shield section and platinum is used as the lining material other than at the shield section, it is possible to achieve welding without a gap between the shield section and the platinum lining material, while the strength of the weld zone after welding is also sufficiently high. An autoclave of this type is particularly advantageous.

When the shield section of the autoclave and the lined sections other than at the shield section are to be used in a permanently bonded state, the bonded sections between the shield section of the autoclave and the lined sections other than the shield section are preferably welded.

The shield system of the shield section is not particularly restricted, and may be a cone seal system, gasket system or Grayloc system, for example. Regardless of the seal system, preventing wear and fusion of the shield section material is essential for repeated use of the autoclave. The autoclave of the invention has exceptionally satisfactory durability with repeated use of the autoclave by using a specific shield section material, with any of the shield systems mentioned above.

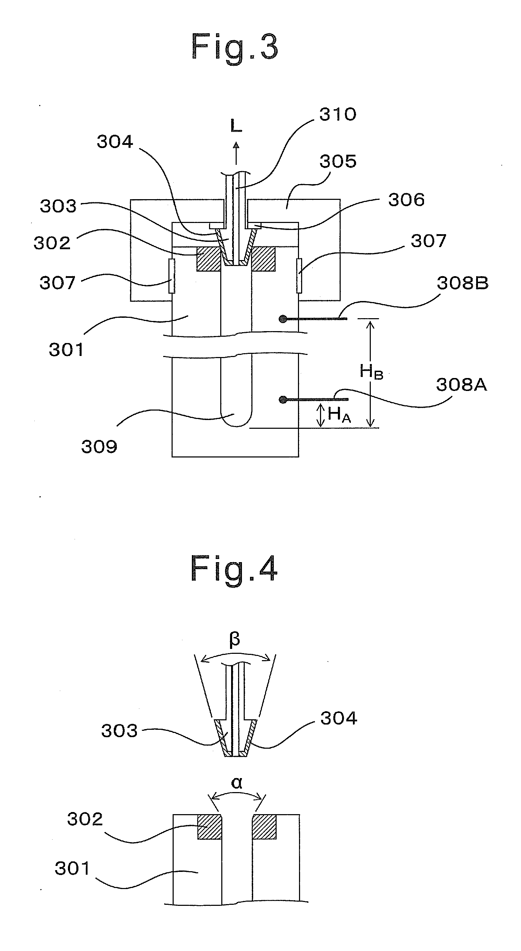

Fig. 3 is a simplified cross-sectional view of an autoclave according to the invention, and Fig. 4 is a simplified cross-sectional view of the shield section of an autoclave according to the invention. The autoclave shown in Fig. 3 and Fig. 4 is a cone seal-type apparatus, constructed to allow hermetic sealing between a main body trunk 301 and a cone cover 303. The cone cover 303, a buffer packing material 306 and an outside cover 305 are set on the main body trunk 301, and the main body trunk 301 and outside cover 305 are anchored with a screw section 307 to seal the autoclave. A main body trunk shield section 302 is formed in the main body trunk 301, and a cone cover shield section 304 is formed in the cone cover 303. The temperature on the inside cylinder 309 in which the contents are housed is controlled by a thermocouple 308A, 308B. In the example shown in Fig. 3, the temperature of the lower level of the autoclave is measured by inserting the thermocouple 308A into the autoclave at a position within H_{A} (for example, 15 mm) in the height direction from the bottom of the inside cylinder 309. The temperature of the upper level of the autoclave is measured by inserting the thermocouple 308B into the autoclave at a position within H_{B} (for example, 150 mm) in the height direction from the bottom of the inside cylinder 309. The inside cylinder 309 is connected to upper tubing by connection L through a conduit 310.

In a cone seal-type autoclave, the autoclave can be satisfactorily sealed if the angle α formed by the main body trunk shield section 302 and the angle β formed by the cone cover shield section 304 are essentially equal. Preferably, angle P is slightly smaller than angle α, such as 60° for angle α and 59° for angle β. This will provide more satisfactory sealing.

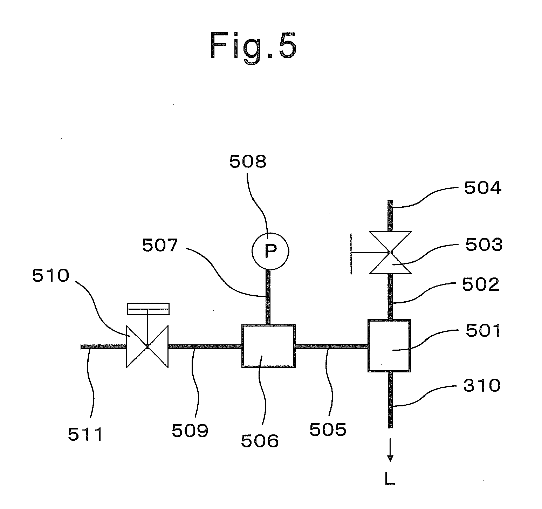

Fig. 5 is a schematic diagram showing an example of upper tubing connected to an autoclave according to the invention. The upper tubing shown in Fig. 5 is connected from the autoclave by a connection L through the conduit 310. The conduit 310 is divided into tubing 502 and tubing 505, via a three-way connecting joint 501. A solvent (ammonia) and an exchange gas (such as nitrogen) are supplied from the tubing 504 to the tubing 502 through a hand valve 503. The tubing 505 is divided into tubing 507 and tubing 509, via a three-way connecting joint 506. The tubing 507 leads to a pressure sensor 508. The tubing 509 leads to tubing 511 through an automatic valve 510. The tubing 511 communicates with the external air. Thus, the automatic valve 510 is opened when the pressure sensor 508 has detected a pressure value exceeding a specified value, thus allowing excessive pressure increase inside the autoclave to be avoided.

For example, in the case of a cone seal-type autoclave as shown in Fig. 3 and Fig. 4, the "shield section" refers to both the main body trunk shield section 302 on the main body trunk side and the cone cover shield section 304 on the cone cover side. In this case, both shield section materials are alloys of iridium and platinum or iridium alone, the proportion of iridium among the entire constituent elements of each material being between 20 mass% and 100 mass%.

The thickness of the shield section of the autoclave may be a thickness that prevents corrosion of the shield section by high-temperature, high-pressure ammonia, while also avoiding wear, damage and heat-induced fusion of the shield section. Specifically, the thickness of the shield section is preferably 0.1 mm to 30 mm, more preferably 0.3 mm to 20 mm and even more preferably 0.5 mm to 10 mm. If the shield section is 0.1 mm or greater, the shield section will not easily detach and will be resistant to damage-induced cracking. On the other hand, since the shield section material is a costly precious metal material, it is economically advantageous for its thickness to be no greater than 30 mm.

The autoclave of the invention is particularly applicable in an ammonothermal method using an acidic mineralizer. However, it may also be applied in an ammonothermal method utilizing an alkaline mineralizer or a nearly neutral metal salt mineralizer, instead of an acidic mineralizer. The acidic mineralizer, alkaline mineralizer or nearly neutral metal salt mineralizer is dissolved in an ammonia solvent for use, and has the function of promoting dissolution of the nitrogen compound starting material. For example, the alkaline mineralizer may be a mineralizer containing an alkali metal element. More specific examples of alkaline mineralizers include alkali metal amides such as NaNH₂, KNH₂ and LiNH₂. Nearly neutral metal salt mineralizers include magnesium halides such as MgCl₂ and MgBr₂, calcium halides such as CaCl₂ and BaBr₂, and alkali metal halide compounds such as NaCl, NaBr, KCl, KBr, CsCl, CsBr, LiCl and LiBr.

Production of a Ga-containing nitride single crystal using the autoclave of the invention can be carried out by the following procedure, for example. First, a mineralizer; a starting material containing at least one material selected from the group consisting of Ga-containing nitride polycrystals, Ga-containing nitrides and Ga-containing nitride precursors, and if necessary an oxygen-removing additive, are placed in an autoclave, an ammonia solvent is introduced into the autoclave, and the autoclave is sealed. Before ammonia is introduced into the autoclave, preferably the interior of the autoclave is deaerated to maintain a vacuum, and the oxygen and moisture are removed. When ammonia is to be introduced into the autoclave, it is preferred for the autoclave to be cooled to below the boiling point of ammonia. This will facilitate sealing of the autoclave because of the low vapor pressure of ammonia.

Next, a target single crystal is grown from the starting material at a temperature and pressure set to the desired range. More specifically, the temperature (T1) at the single crystal growth site is set to 600°C to 850°C, the relationship between the temperature (T1) at the single crystal growth site and the temperature (T2) at the starting material feeder site is set so that T1 > T2, and the pressure in the autoclave is set to 40 MPa to 250 MPa, and a Ga-containing nitride single crystal is grown from a starting material containing at least one material selected from the group consisting of Ga-containing nitride polycrystals, Ga-containing nitrides and Ga-containing nitride precursors.

The autoclave of the invention is particularly applicable in the method for producing a Ga-containing nitride single crystal according to the invention as described above. However, the autoclave of the invention may also be applied to production of other Group 13 element nitride single crystals. In this case, a starting material containing a Group 13 element may be used to grow a single crystal by a method following the procedure described above.

### [Examples]

The present invention will now be explained in detail using examples and comparative examples. The materials, amounts, proportions, processing and procedures employed in the examples may be modified as appropriate within the scope of the invention. However, the scope of the invention is not to be considered as restricted by these examples.

Because it is exceedingly difficult to measure the internal temperature of an autoclave in a supercritical state, the empty autoclave is set in a heater with the cover closed and the valve removed, and the temperature of each section of the inner wall of the autoclave is measured using a thermocouple inserted through the conduit, with the heater controlled under the same conditions as for the reaction. The temperature value is the internal temperature of the autoclave in a supercritical state.

The terms "reverse" and "normal" in the tables, regarding the placement, have the following meanings.

Reverse: The starting material feeder site is placed at a higher position in the vertical direction from the single crystal growth site.

Normal: The starting material feeder site is placed at a lower position in the vertical direction from the single crystal growth site.

### [Examples 1 to 7 and Comparative Examples 1 to 8]

Examples 1 to 7 and Comparative Examples 1 to 8 are examples of single crystal growth using seed crystals.

### (Example 1)

A GaN single crystal grain was produced by an ammonothermal method using a GaN polycrystal starting material produced by a gas phase method. A grain with a length of 4 mm and a thickness of about 0.7 mm, euhedrally formed from a GaN single crystal produced by spontaneous nucleation, was used as the seed crystal. The autoclave used was a vertical autoclave (inner dimensions: 8 mm diameter, 250 mm length, approximately 12.5 mL internal volume) formed of a RENE41 material, lined with platinum on the inner side except for the shield section, and lined with a platinum-based alloy (alloy of iridium and platinum, with an iridium content of 20 mass%) on the inner side of the shield section. The seed crystal was anchored with a platinum wire and suspended at a height of about 25 mm from the bottom of the inside of the autoclave.

GaN polycrystals (size: approximately 1 mm to 5 mm) produced by a gas phase method were placed in an amount of 5.0 g in a cylindrical container fabricated from a platinum sheet with a thickness of 0.3 mm (with outer dimensions: diameter = 5.5 mm, height = 100 mm, and with six 0.5 mm width × 80 mm length slits formed in the sides and five 0.5 mm diameter holes formed in the bottom). The cylindrical container was filled with packed polycrystals. The cylindrical container was set so that a gap was formed 50 mm in the height direction from the inside bottom of the autoclave in which the seed crystal had been set.

Next, 0.426 g of ammonium chloride with a purity of 99.99 mass% was placed and the cover of the autoclave was closed. The container was connected to a vacuum pump and the interior was evacuated. A turbo-molecular pump was used for evacuation to a pressure of no greater than 1.0 × 10⁻⁴ Pa directly above the pump. Dry ice and a refrigerant were then used to cool the autoclave, and 5.0 g of ammonia with a purity of 99.999 mass% was filled in without contacting the autoclave contents with the external air, and the valve was closed. The filled ammonia volume corresponded to 59 vol% of the autoclave internal volume, based on the density of ammonia at -33°C.

Next, the autoclave was set in a heater and the autoclave was heated. The mean temperature at the polycrystal placement site (the starting material feeder site) was kept at 656°C (681°C, 663°C, 645°C, 646°C and 644°C at equally spaced measuring locations), and the mean temperature at the single crystal growth site was 697°C (698°C, 699°C and 694°C at equally spaced measuring locations). The pressure in the autoclave was 125 MPa.

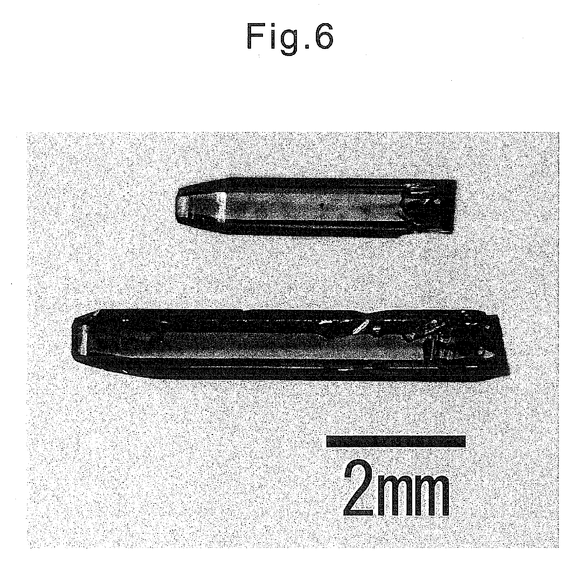

After maintaining this state for 168 hours, it was naturally cooled and the interior ammonia was discharged. Fig. 6 is a diagram showing an optical microscope photograph of a crystal grain of the same size as the seed crystal used in Example 1 (top), and a nitride single crystal obtained by growth in Example 1 (bottom). As seen from Fig. 6, satisfactory crystal growth was observed in Example 1. The seed crystal grew from the original shape, and reached a length of 6.1 mm and a thickness of 1.1 mm. Estimation of the single crystal growth rate at this time was 300 µm/day in the lengthwise direction and 57 µm/day in the thickness direction.

The obtained single crystal was mounted on a non-reflecting Si board and subjected to X-ray diffraction measurement which resulted in diffraction only from the m face, indicating that it was a single crystal.

X-ray diffraction measurement confirmed that the lengthwise direction of the obtained single crystal was the c-axis. The half-width of the diffraction peak from the GaN (0002) face was evaluated by measuring the X-ray rocking curve, giving a result of 28 arcsec and confirming that it was a high-quality crystal.

### (Example 2)

Single crystal growth was conducted with the same placement and temperature conditions as Example 1, except that the amount of filled ammonia was 4.2 g, the filling volume was about 50 vol% of the container based on the density at -33°C, the amount of ammonium chloride was reduced to 0.357 g, and the reaction time was lengthened (480 hours). The pressure in the autoclave during crystal growth was 70 MPa, based on the ammonia filling volume. After maintaining this state for 480 hours, it was naturally cooled and the interior ammonia was discharged. The seed crystal grew from the original shape, and reached a length of 7.2 mm and a thickness of 1.7 mm. Estimation of the growth rate at this time was 160 µm/day in the lengthwise direction and 50 µm/day in the thickness direction. The obtained single crystal was mounted on a non-reflecting Si board and subjected to X-ray diffraction measurement which resulted in diffraction only from the m face, indicating that it was a single crystal.

### (Example 3)

The crystal grain with a thickness of 1.7 mm obtained in Example 2 was cut perpendicular to the lengthwise direction, to obtain a GaN single crystal substrate with sides (that is, lengths in the m-axis direction) of approximately 1.5 mm and a thickness of 0.5 mm. This seed crystal was used to grow a single crystal with the same placement, charging, temperature, pressure and reaction time conditions as in Example 1. The seed crystal grew from the original shape, growing to a thickness of 0.9 mm and a side length of 1.8 mm. Estimation of the growth rate at this time was 57 µm/day in the thickness direction (the c-axis direction) and 43 µm/day in the side length direction (m-axis direction).

### (Example 4)

A GaN self-supporting substrate fabricated by HVPE (approximately 5 mm × approximately 10 mm × approximately 0.4 mm thickness, weight: approximately 0.15 g) was used as the seed crystal. Single crystal growth was conducted with the same placement and temperature conditions as in Example 1, except that a platinum sheet having a 2 mm-diameter hole opened at the center of a 7 mm-diameter disc, at a location at a height of 50 mm from the bottom of the inside of the autoclave, was situated as a partition plate so that the diameter direction was in the horizontal direction, the amount of ammonia filled was 4.3 g, the amount of ammonium chloride was 0.365 g and the retention time (that is, the single crystal growth time) was 96 hours. The pressure in the autoclave during crystal growth was 80 MPa.

The seed crystal removed out after growth had a weight of 0.37 g and a thickness of 0.95 mm. Estimation of the growth rate in the thickness direction was 135 µm/day.

The peak half-width, based on the X-ray rocking curve for the diffraction peak from the GaN (0002) face of the grown crystal, was evaluated to be 50 arcsec on the Ga-surface side and 30 arcsec on the N-surface side.

### (Example 5)

Single crystal growth was conducted with the same placement, temperature and reaction time conditions as Example 4, except that the amount of ammonia filled was 5.0 g and the amount of ammonium chloride was 0.426 g. The pressure in the autoclave during crystal growth was 125 MPa.

The seed crystal removed out after growth had a weight of 0.45 g and a thickness of 1.1 mm. Estimation of the growth rate in the thickness direction was 175 µm/day. The peak half-width, based on the X-ray rocking curve for the diffraction peak from the GaN (0002) face of the grown crystal, was evaluated to be 72 arcsec on the Ga-surface side and 137 arcsec on the N-surface side.

### (Example 6)

Single crystal growth was conducted with the same charging, placement and reaction time conditions as Example 5, except that the mean temperature at the polycrystal placement site (i.e. the starting material feeder site) was kept at 702°C (725°C, 715°C, 695°C, 690°C and 685°C at equally spaced measuring locations), and the mean temperature at the single crystal growth site was 749°C (752°C, 749°C and 745°C at equally spaced measuring locations). The pressure in the autoclave during crystal growth was 140 MPa.

The seed crystal removed out after growth had a weight of 0.47 g and a thickness of 1.15 mm. Estimation of the growth rate in the thickness direction was 185 µm/day. The peak half-width, based on the X-ray rocking curve for the diffraction peak from the GaN (0002) face of the grown crystal, was evaluated to be 104 arcsec on the Ga-surface side and 61 arcsec on the N-surface side.

### (Example 7)

Single crystal growth was conducted with the same placement, charging and reaction time conditions as Example 5, except that the mean temperature at the polycrystal placement site was kept at 610°C (615°C, 612°C, 610°C, 608°C and 605°C at equally spaced measuring locations), and the mean temperature at the single crystal growth site was 660°C (662°C, 660°C and 658°C at equally spaced measuring locations). The pressure in the autoclave during crystal growth was 105 MPa.

The seed crystal removed out after growth had a weight of 0.30 g and a thickness of 0.85 mm. Estimation of the growth rate in the thickness direction was 110 µm/day. The peak half-width, based on the X-ray rocking curve for the diffraction peak from the GaN (0002) face of the grown crystal, was evaluated to be 169 arcsec on the Ga-surface side and 187 arcsec on the N-surface side.

### (Comparative Example 1)

Single crystal growth was conducted with the same placement and charging conditions as Example 1, except that the mean temperature at the polycrystal placement site was kept at 638°C (620°C, 633°C, 645°C, 650°C and 644°C at equally spaced measuring locations), and the mean temperature at the single crystal growth site was 601°C (590°C, 602°C and 610°C at equally spaced measuring locations). The pressure in the autoclave during crystal growth was 96 MPa.

After maintaining this state for 168 hours, it was naturally cooled, the ammonia was discharged, and upon confirming the interior of the autoclave, the set seed crystal was found to have completely melted and disappeared.

### (Comparative Example 2)

Single crystal growth was conducted with the same placement, temperature and reaction time conditions as Example 1, except that the amount of filled ammonia was 2.5 g, the ammonia volume was about 30 vol% of the container based on the ammonia density at -33°C, and the amount of ammonium chloride as the mineralizer was reduced to 0.213 g. The pressure in the autoclave during crystal growth was 27 MPa. After maintaining this state for 168 hours, it was naturally cooled, the ammonia was discharged, and upon confirming the interior of the autoclave, the set seed crystal and polycrystal starting material were found to have remained essentially unchanged, with no crystal growth occurring.

### (Comparative Example 3)

A GaN single crystal grain was produced by an ammonothermal method using a GaN polycrystal starting material produced by a gas phase method. A grain with a length of 4 mm and a thickness of about 0.7 mm, euhedrally formed from a GaN single crystal produced by spontaneous nucleation, was used as the seed crystal. The autoclave used was a vertical autoclave (inner dimensions: 8 mm diameter, 250 mm length, approximately 12.5 mL internal volume) formed of a RENE41 material, lined with platinum on the inner side except for the shield section, and lined with a platinum-based alloy (alloy of iridium and platinum, with an iridium content of 20 mass%) on the inner side of the shield section.

GaN polycrystals (size: approximately 1 mm to 5 mm) produced by a gas phase method were placed in an amount of 5.0 g in a cylindrical container fabricated from a platinum sheet with a thickness of 0.3 mm (with outer dimensions of diameter: 5.5 mm, height: 100 mm, six 0.5 mm width × 80 mm length slits formed in the sides and five 0.5 mm diameter holes formed in the bottom). The cylindrical container was filled with packed polycrystals. The container was placed in an autoclave, and the container was set so that the GaN polycrystals were situated at a location from 0 mm to a height of about 100 mm from the bottom of the inside of the autoclave.

The seed crystal was anchored by a platinum wire and placed at a location at a height of 150 mm from the bottom of the inside of the autoclave. Next, 0.426 g of ammonium chloride with a purity of 99.99 mass% was placed and the cover of the autoclave was closed.

The container was connected to a vacuum pump and the interior was evacuated. A turbo-molecular pump was used for evacuation to a pressure of no greater than 1.0 × 10⁻⁴ Pa directly above the pump. Dry ice and a refrigerant were then used to cool the autoclave, and 5.0 g of ammonia with a purity of 99.999 mass% was filled in without contacting the autoclave contents with the external air, and the valve was closed. The filled ammonia volume corresponded to 59 vol% of the autoclave internal volume, based on the density of ammonia at -33°C.

Next, the autoclave was set in a heater and the autoclave was heated. The mean temperature at the polycrystal placement site (a location at a height of 0 to 100 mm from the bottom of the inside of the autoclave) was kept at 698°C (708°C, 702°C, 698°C, 695°C and 685°C at equally spaced measuring locations), and the mean temperature at the single crystal growth site (a location at a height of 125 to 175 mm from the bottom of the inside of the autoclave) was 665°C (675°C, 670°C, 660°C, 663°C and 658°C at equally spaced measuring locations). The pressure in the autoclave was 125 MPa.

After maintaining this state for 96 hours, it was naturally cooled and the interior ammonia was discharged. Upon confirming the interior of the autoclave, the set seed crystal had completely melted and disappeared.

### (Comparative Example 4)

Single crystal growth was conducted with the same placement and charging conditions as Example 1, except that the mean temperature at the polycrystal placement site was kept at 509°C (548°C, 521°C, 500°C, 492°C and 485°C at equally spaced measuring locations), the mean temperature at the single crystal growth site was 581°C (583°C, 581°C and 578°C at equally spaced measuring locations), and the crystal growth time was shortened. The pressure in the autoclave during crystal growth was 100 MPa. After maintaining this state for 96 hours, it was naturally cooled and the interior ammonia was discharged. Upon confirming the interior of the autoclave, the set seed crystal was found to have completely melted and disappeared.

### (Comparative Example 5)

Single crystal growth was conducted in the same manner as Example 1, except that the mean temperature at the polycrystal placement site (i.e. the starting material feeder site) was kept at 697°C (685°C, 698°C, 705°C, 700°C and 699°C at equally spaced measuring locations), the mean temperature at the single crystal growth site was 661°C (658°C, 661°C and 664°C at equally spaced measuring locations), and the crystal growth time was shortened (96 hours). The pressure in the autoclave during crystal growth was 125 MPa. After maintaining this state for 96 hours, it was naturally cooled, the ammonia was discharged, and upon confirming the interior of the autoclave, the set seed crystal was found to have completely melted and disappeared.

### (Comparative Example 6)

Single crystal growth was conducted with the same placement conditions as in Comparative Example 3, except that a GaN self-supporting substrate fabricated by HVPE (approximately 5 mm × approximately 10 mm × approximately 0.4 mm thickness, weight: approximately 0.15 g) was used as the seed crystal, a platinum sheet having a 2 mm-diameter hole opened at the center of a 7 mm-diameter disc, at a location at a height of about 50 mm from the bottom of the inside of the autoclave, was situated as a partition plate so that the diameter direction was in the horizontal direction, the amount of ammonia filled was 5.2 g, the amount of ammonium chloride was 0.443 g and the heat holding conditions were changed. The mean temperature at the polycrystal placement site (a location at a height of 0 to 100 mm from the bottom of the inside of the autoclave) was kept at 554°C (563°C, 562°C, 553°C, 547°C and 544°C at equally spaced measuring locations), and the mean temperature at the single crystal growth site (a location at a height of 125 to 175 mm from the bottom of the inside of the autoclave) was 453°C (470°C, 462°C, 450°C, 443°C and 438°C at equally spaced measuring locations), for 168 hours. The pressure in the autoclave was 120 MPa.

The seed crystal removed out after growth had a weight of 0.23 g and a thickness of 0.57 mm. Estimation of the growth rate in the thickness direction was 25 µm/day. The peak half-width, based on the X-ray rocking curve for the diffraction peak from the GaN (0002) face of the grown crystal, was evaluated to be 173 arcsec on the Ga-surface side and 3420 arcsec on the N-surface side.

### (Comparative Example 7)

Growth was conducted with the same placement and reaction time conditions as Comparative Example 6, except that the amount of ammonia filled was 4.7 g and the amount of ammonium chloride was 0.400 g. The pressure in the autoclave during crystal growth was 90 MPa.

The seed crystal removed out after growth had a weight of 0.17 g and a thickness of 0.43 mm. Estimation of the growth rate in the thickness direction was 4.3 µm/day. The peak half-width, based on the X-ray rocking curve for the diffraction peak from the GaN (0002) face of the grown crystal, was evaluated to be 151 arcsec on the Ga-surface side and 181 arcsec on the N-surface side.

### (Comparative Example 8)

The same placement, charging and pressure conditions were used as in Comparative Example 3, except that a GaN self-supporting substrate fabricated by HVPE (approximately 5 mm × approximately 10 mm × approximately 0.4 mm thickness, weight: approximately 0.15 g) was used as the seed crystal, a platinum sheet having a 2 mm-diameter hole opened at the center of a 7 mm-diameter disc, at a location at a height of about 50 mm from the bottom of the inside of the autoclave, was situated as a partition plate so that the diameter direction was in the horizontal direction. After maintaining this state for 96 hours, it was naturally cooled and the interior ammonia was discharged. Upon confirming the interior of the autoclave, the set seed crystal was found to have completely melted and disappeared.

### [Examples 8 to 11 and Comparative Examples 9 to 11]

Examples 8 to 11 and Comparative Examples 9 to 11 are examples of single crystal growth without using seed crystals.

### (Example 8)

GaN polycrystals (size: approximately 1 mm to 5 mm) produced by a gas phase method were placed in an amount of 5.0 g in a cylindrical container fabricated from a platinum sheet with a thickness of 0.3 mm (with outer dimensions of diameter: 5.5 mm, height: 100 mm, six 0.5 mm width × 80 mm length slits formed in the sides and five 0.5 mm diameter holes formed in the bottom). The packed polycrystals filled the cylindrical container. The polycrystal-packed container was set in a vertical autoclave (inner dimensions: 8 mm diameter, 250 mm length, approximately 12.5 mL internal volume) formed of a RENE41 material, lined with platinum on the inner side except for the shield section, and lined with a platinum-based alloy (alloy of iridium and platinum, with an iridium content of 20 mass%) on the inner side of the shield section, maintaining a gap 50 mm in the height direction from the inside bottom.

Next, 0.426 g of ammonium chloride with a purity of 99.99 mass% was placed and the cover of the autoclave was closed. The container was connected to a vacuum pump and the interior was evacuated. A turbo-molecular pump was used for evacuation to a pressure of no greater than 1.0 × 10⁻⁴ Pa directly above the pump. Dry ice and a refrigerant were then used to cool the autoclave, 5.0 g of ammonia with a purity of 99.999 mass% was filled in without contacting the autoclave contents with the external air, and the valve was closed. The filled ammonia volume corresponded to 59 vol% of the autoclave internal volume, based on the density of ammonia at -33°C.

Next, the autoclave was set in a heater and the autoclave was heated. The mean temperature at the polycrystal placement site was kept at 621°C (680°C, 647°C, 610°C, 588°C and 580°C at equally spaced measuring locations), and the mean temperature at the single crystal growth site was 715°C (723°C, 720°C and 701°C at equally spaced measuring locations). The pressure in the autoclave was 115 MPa.

After maintaining this state for 168 hours, it was naturally cooled and the interior ammonia was discharged. Single crystals with lengths of 1 mm to 5 mm were deposited on the inner wall surface of the autoclave at the single crystal growth site and on the bottom. The weight of the washed and dried single crystals was 1.5 g. Polycrystals remained in the platinum container in an amount of 3.0 g. The difference of 0.5 g between the charging amount and the amount of produced single crystals and residual polycrystals was attributed to outflow in the washing step or adhesion to the interior of the autoclave.

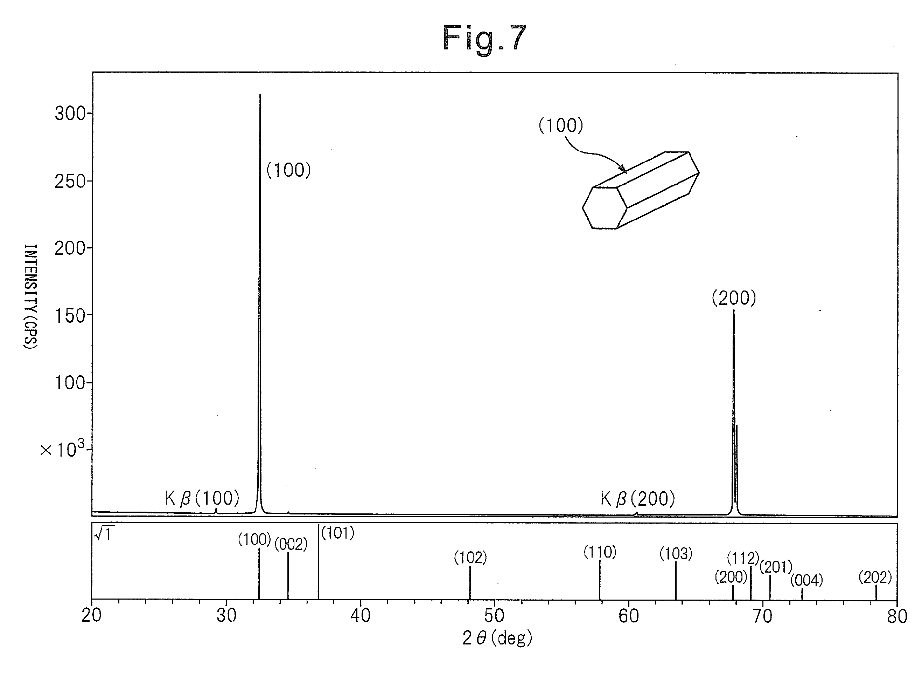

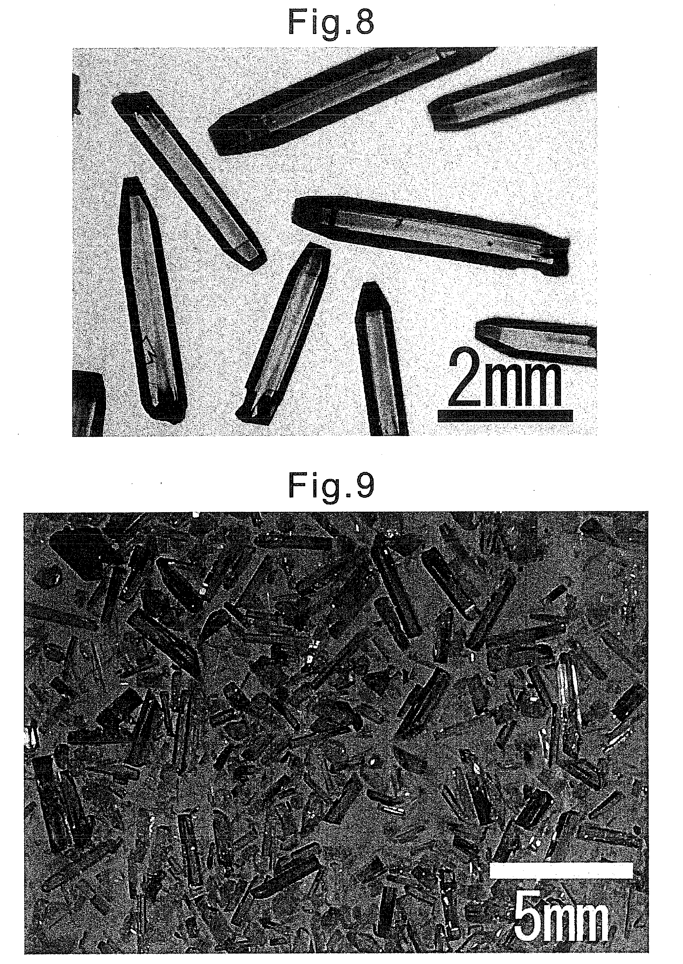

Fig. 7 is a diagram showing an X-ray diffraction pattern (XRD pattern) for a GaN single crystal obtained in Example 8. Fig. 8 is an optical microscope photograph of a GaN single crystal obtained in Example 8. As shown in Fig. 7, the obtained crystal grain was confirmed by X-ray diffraction to be hexagonal GaN. When one single crystal grain of regular form was mounted on a non-reflecting Si board and subjected to X-ray diffraction measurement, diffraction was obtained only from the m face, indicating that it was a single crystal. Observation of the obtained single crystal was as shown in Fig. 8.

### (Example 9)

Single crystal growth was conducted with the same placement, charging, temperature, pressure and reaction time conditions as Example 8, except that a platinum mesh with 0.5 mm aperture was situated at a location at a height of 10 mm from the bottom of the inside of the autoclave. Upon completion of the experiment, it was confirmed that single crystals of regular form with lengths of 3 mm to 5 mm had been deposited on the mesh.

The obtained crystal grains were confirmed by X-ray diffraction to be hexagonal GaN. When one single crystal grain of regular form was mounted on a non-reflecting Si board and subjected to X-ray diffraction measurement, diffraction was obtained only from the m face, indicating that it was a single crystal.

### (Example 10)

Single crystal growth was conducted with the same placement conditions as Example 1, except that the amount of filled ammonia was 4.2 g, the filling volume was approximately 50 vol% of the container based on the NH₃ density at -33°C, and the amount of ammonium chloride as the mineralizer was reduced to 0.357 g. The pressure in the autoclave during crystal growth was 70 MPa, based on the ammonia filling volume. After maintaining this state for 168 hours, it was naturally cooled and the interior ammonia was discharged. Single crystals with lengths of about 0.5 mm to 3 mm were deposited on the inner wall surface of the autoclave at the single crystal growth site and on the bottom, and the single crystal weight after washing and drying was 0.9 g. Polycrystals remained in the platinum container in an amount of 3.5 g. The difference of 0.6 g between the charging amount and the amount of produced single crystal and residual polycrystals was attributed to outflow in the washing step or adhesion to the interior of the autoclave.

The obtained crystal grains were confirmed by X-ray diffraction to be hexagonal GaN. When one single crystal grain of regular form was mounted on a non-reflecting Si board and subjected to X-ray diffraction measurement, diffraction was obtained only from the m face, indicating that it was a single crystal.

### (Example 11)

GaN polycrystals (size: approximately 1 mm to 5 mm) produced by a gas phase method were placed in an amount of 5.0 g in a cylindrical container fabricated from a platinum sheet with a thickness of 0.3 mm (with outer dimensions of diameter: 5.5 mm, height: 100 mm, six 0.5 mm width × 80 mm length slits formed in the sides and five 0.5 mm diameter holes formed in the bottom). The packed polycrystals filled the cylindrical container. The polycrystal-filled container was set in a vertical autoclave (inner dimensions: 8 mm diameter, 250 mm length, approximately 12.5 mL internal volume) formed of a RENE41 material, lined with platinum on the inner side except for the shield section, and lined with a platinum-based alloy (alloy of iridium and platinum, with an iridium content of 20 mass%) on the inner side of the shield section, maintaining a gap 50 mm in the height direction from the inside bottom.

Next, 0.426 g of ammonium chloride with a purity of 99.99 mass% was placed and the cover of the autoclave was closed. The container was connected to a vacuum pump and the interior was evacuated. A turbo-molecular pump was used for evacuation to a pressure of no greater than 1.0 × 10⁻⁴ Pa directly above the pump. Dry ice and a refrigerant were then used to cool the autoclave, and 5.0 g of ammonia with a purity of 99.999 mass% was filled in without contacting the autoclave contents with the external air, and the valve was closed. The filled ammonia volume corresponded to 59 vol% of the autoclave internal volume, based on the density of ammonia at -33°C.

Next, the autoclave was set in a heater and the autoclave was heated. The mean temperature at the polycrystal placement site was kept at 656°C (681°C, 663°C, 645°C, 646°C and 644°C at equally spaced measuring locations), and the mean temperature at the single crystal growth site was 697°C (698°C, 699°C and 694°C at equally spaced measuring locations). The pressure in the autoclave was 125 MPa.

After maintaining this state for 168 hours, it was naturally cooled and the interior ammonia was discharged. Single crystals with lengths of about 1 mm to 5 mm were deposited on the inner wall surface of the autoclave at the single crystal growth site and on the bottom, and the single crystal weight after washing and drying was 1.1 g. Polycrystals remained in the platinum container in an amount of 3.5 g. The difference of 0.4 g between the charging amount and the amount of produced single crystals and residual polycrystals was attributed to outflow in the washing step or adhesion to the interior of the autoclave.

The obtained crystal grains were confirmed by X-ray diffraction to be hexagonal GaN. When one single crystal grain of regular form was mounted on a non-reflecting Si board and subjected to X-ray diffraction measurement, diffraction was obtained only from the m face, indicating that it was a single crystal.

### (Comparative Example 9)

GaN polycrystals (size: approximately 1 mm to 5 mm) produced by a gas phase method were placed in an amount of 5.0 g in a cylindrical container fabricated from a platinum sheet with a thickness of 0.3 mm (with outer dimensions of diameter: 5.5 mm, height: 100 mm, six 0.5 mm width × 80 mm length slits formed in the sides and five 0.5 mm diameter holes formed in the bottom). The packed polycrystals filled the cylindrical container. The polycrystal-packed container was set in a vertical autoclave (inner dimensions: 8 mm diameter, 250 mm length, approximately 12.5 mL internal volume) formed of a RENE41 material, lined with platinum on the inner side except for the shield section, and lined with a platinum-based alloy (alloy of iridium and platinum, with an iridium content of 20 mass%) on the inner side of the shield section, maintaining a gap 50 mm in the height direction from the inside bottom.

Next, 0.426 g of ammonium chloride with a purity of 99.99 mass% was placed and the cover of the autoclave was closed. The container was connected to a vacuum pump and the interior was evacuated. A turbo-molecular pump was used for evacuation to a pressure of no greater than 1.0 × 10⁻⁴ Pa directly above the pump. Dry ice and a refrigerant were then used to cool the autoclave, 5.0 g of ammonia with a purity of 99.999 mass% was filled in without contacting the autoclave contents with the external air, and the valve was closed. The filled ammonia volume corresponded to 59 vol% of the autoclave internal volume, based on the density of ammonia at -33°C.

Next, the autoclave was set in a heater and the autoclave was heated. The mean temperature at the polycrystal placement site was kept at 638°C (620°C, 633°C, 645°C, 650°C and 644°C at equally spaced measuring locations), and the mean temperature at the location corresponding to the single crystal growth site in Example 11 was 600°C (590°C, 602°C and 610°C at equally spaced measuring locations). The pressure in the autoclave was 96 MPa.

After maintaining this state for 168 hours, it was naturally cooled and the interior ammonia was discharged. No deposition could be confirmed on the inner wall surface of the autoclave around the site corresponding to the single crystal growth site of Example 11, or on the bottom. A fine powdered deposition was adhering to the inner wall surface of the autoclave surrounding the polycrystal placement site and near the conduit at the upper part of the autoclave, and this was confirmed to be hexagonal GaN by X-ray diffraction. However, the deposition had an aggregate form and could not be separated as single crystal grains. Scanning electron microscope observation revealed the presence of nearly hexagonal columnar shapes, but the deposition was aggregated on the micron size and could not be removed out as single crystals.

### (Comparative Example 10)

Single crystal growth was conducted with the same placement, temperature and reaction time conditions as Example 11, except that the amount of filled ammonia was 3.0 g, the filling volume was about 36 vol% of the container based on the ammonia density at -33°C, and the amount of ammonium chloride as the mineralizer was reduced to 0.256 g. The pressure in the autoclave during crystal growth was 30 MPa, based on the ammonia filling volume. After maintaining this state for 168 hours, it was naturally cooled and the interior ammonia was discharged. The remaining polycrystal starting material was 4.8 g, with a slight amount having melted, but almost no recoverable deposition was found inside the autoclave.

### (Comparative Example 11)

An experiment was conducted with the same placement, charging, temperature, pressure and reaction time conditions as Comparative Example 6, except that the seed crystal of Comparative Example 6 was not used. The single crystal growth site was at the same location as the single crystal growth site of Comparative Example 6. After maintaining the state for 168 hours, a fine powdered deposition was adhering to the inner wall of the autoclave at the single crystal growth site and near the conduit at the upper part of the autoclave, and this was confirmed to be hexagonal GaN by X-ray diffraction. However, the deposition was aggregate-like and could not be separated as single crystal grains.

The results for Example 1 to Example 11 and Comparative Example 1 to Comparative Example 11 are shown in Tables 1 to 3 below.

**[Table 1]**

| Example No. | Seed crystal | Placement | Temperature at single crystal growth site | Relationship between top and bottom temperatures | Relationship between T1 andT2 | gΔT (= T1-T2) | Pressure | Baffle | Single crystal growth rate | |
|---|---|---|---|---|---|---|---|---|---|---|
| | | | | | | | | | c-axis direction | Lateral direction |
| Example 1 | Spontaneous nucleation | Reverse | 697°C | top < bottom | T1>T2 | 37°C | 125 MPa | No | 300 µm/day | 57 µm/day |
| Example 2 | Spontaneous nucleation | Reverse | 697°C | top < bottom | T1>T2 | 37°C | 70 MPa | No | 160 µm/day | 50 µm/day |
| Example 3 | Cut out from 2 | Reverse | 697°C | top < bottom | T1>T2 | 37°C | 125 MPa | No | 57 µm/day | 43 µm/day |
| Example 4 | HVPE substrate | Reverse | 697°C | top < bottom | T1>T2 | 37°C | 80 MPa | Yes | 137.5 µm/day | Not evaluated |
| Example 5 | HVPE substrate | Reverse | 697°C | top < bottom | T1>T2 | 37°C | 125 MPa | Yes | 175 µm/day | Not evaluated |
| Example 6 | HVPE substrate | Reverse | 750°C | top < bottom | T1>T2 | 50°C | 140 MPa | Yes | 187.5 µm/day | Not evaluated |
| Example 7 | HVPE substrate | Reverse | 660°C | top < bottom | T1>T2 | 50°C | 105 MPa | Yes | 112.5 µm/day | Not evaluated |
| Comp. Ex. 1 | Spontaneous nucleation | Reverse | 600°C | top > bottom | T1<T2 | -37°C | 96 MPa | No | Complete melting of seed crystal | |
| Comp. Ex. 2 | Spontaneous nucleation | Reverse | 697°C | top < bottom | T1>T2 | 37°C | 27 MPa | No | No change | |
| Comp. Ex. 3 | Spontaneous nucleation | Normal | 660°C | top < bottom | T1<T2 | -37°C | 125 MPa | No | Complete melting of seed crystal | |
| Comp. Ex. 4 | Spontaneous nucleation | Reverse | 580°C | top < bottom | T1>T2 | 80°C | 100 MPa | No | Complete melting of seed crystal | |
| Comp. Ex. 5 | Spontaneous nucleation | Reverse | 661°C | top > bottom | T1<T2 | -36°C | 125 MPa | No | Complete melting of seed crystal | |
| Comp. Ex. 6 | HVPE substrate | Normal | 450°C | top < bottom | T1<T2 | -100°C | 120 MPa | Yes | 27.1 µm/day | Not evaluated |
| Comp. Ex. 7 | HVPE substrate | Normal | 450°C | top < bottom | T1<T2 | -100°C | 90 MPa | Yes | 4.3 µm/day | Not evaluated |
| Comp. Ex. 8 | HVPE substrate | Normal | 660°C | top < bottom | T1<T2 | -37°C | 125 MPa | Yes | Complete melting of seed crystal | |

**[Table 2]**

| Example No. | XRC-FWHM Ga face | XRC-FWHM N-face |
|---|---|---|
| Example 4 | 50 | 30 |
| Example 5 | 72 | 137 |
| Example 6 | 104 | 61 |
| Example 7 | 169 | 187 |
| Comp. Ex. 6 | 173 | 3420 |
| Comp. Ex. 7 | 151 | 181 |

**[Table 3]**

| Example No. | Seed crystal | Placement | Temperature at single crystal growth site | Relationship between top and bottom temperatures | Relationship between T1 andT2 | gΔT (= T1-T2) | Pressure | Baffle | Single crystal growth |
|---|---|---|---|---|---|---|---|---|---|
| Example 8 | Not used | Reverse | 715°C | top < bottom | T1>T2 | 94°C | 115MPa | No | Deposition |
| Example 9 | Not used | Reverse | 715°C | top < bottom | T1>T2 | 94°C | 115MPa | No | Deposition |
| Example 10 | Not used | Reverse | 715°C | top < bottom | T1>T2 | 94°C | 70MPa | No | Deposition |
| Example 11 | Not used | Reverse | 697°C | top < bottom | T1>T2 | 37°C | 125MPa | No | Deposition |
| Comp. Ex. 9 | Not used | Reverse | 600°C | top > bottom | T1<T2 | -38°C | 96MPa | No | Fine powder at top, unmanageable |
| Comp. Ex. 10 | Not used | Reverse | 697°C | top < bottom | T1>T2 | 87°C | 30MPa | No | No deposition |
| Comp. Ex. 11 | Not used | Normal | 450°C | top < bottom | T1<T2 | -100°C | 120MPa | No | Fine powder at top, unmanageable |

### [Examples 12 to 15 and Comparative Examples 12 to 15]

In Examples 12 to 15 and Comparative Examples 12 to 15, the durability of the autoclave was examined.

### (Examples 12 to 15)

The autoclave shown in Fig. 3 and Fig. 4 was used for growth of GaN single crystals. The material of the autoclave was Rene 41 (Rene is a registered trademark of Alvac Metals Company). The shield section material used for the main body trunk shield section 302 and the cone cover shield section 304 was an alloy of iridium and platinum (iridium content: 20 mass%). The thickness of the alloy of iridium and platinum in the main body trunk shield section 302 was 11 mm on the side of the main body trunk 301 at a location 12 mm below the top surface of the main body in the height direction. The thickness of the cone cover shield section 304 was 1.0 mm. The section of the autoclave contacting with ammonia, other than the shield section, had an inner lining of platinum with a thickness of 0.5 mm. The autoclave had an inside cylinder diameter of 8 mm, an inside cylinder length of about 204 mm and a volume of about 10 ml.

At the bottom of the inside cylinder 309 of the main body trunk 301 of the autoclave there was placed 0.19 g of dried NH₄Cl powder with a purity of 99.99 mass%, as a mineralizer. Next, a platinum net was placed at a location 40 mm above the bottom of the inside cylinder 309 of the main body trunk 301 of the autoclave in the height direction, and eight GaN sheets with a thickness of 0.4 mm, a length of 10 mm and a width of 5 mm, fabricated by HVPE, were placed thereover as GaN single crystal growth starting materials. Next, as shown in Fig. 3, a cone cover 303 was mounted on the main body trunk 301, a buffer packing material 306 and outside cover 305 were set, and the outside cover 305 and main body trunk 301 were tightly screwed shut. An upper tubing having the construction shown in Fig. 5 was also set on top of the cone cover 303.

A heater was placed covering the entire autoclave. Specifically, an upper and lower two-stage heater was set around the center of the main body trunk. As shown in Fig. 3, the temperature of the lower level of the autoclave was measured by inserting the thermocouple 308A into the autoclave at a position 15 mm above the bottom of the inside cylinder 309 of the main body trunk 301, in the height direction. Also, the temperature of the upper level of the autoclave was measured by inserting the thermocouple 308B into the autoclave at a position 150 mm above the bottom of the inside cylinder 309 of the main body trunk 301, in the height direction.

For this example, the upper tubing shown in Fig. 5 was connected to the autoclave. Nitrogen was supplied into the autoclave from the tubing 504 through the hand valve 503, with the automatic valve 510 closed, and the autoclave interior was exchanged with nitrogen gas, after which a vacuum deaeration apparatus was connected to the end of the tubing 504, the hand valve 503 was opened, and the autoclave interior was evacuated to create a vacuum. Next, the tubing 504 and tubing 511 were removed while the hand valve 503 was closed to maintain a vacuum state, and the weight of the autoclave shown in Fig. 3 and the upper tubing with the tubing 504 and tubing 511 removed was measured as a whole. Next, the tubing 504 and tubing 511 were set and the autoclave interior was evacuated in the same manner, after which it was cooled with a dry ice methanol solvent from the outside of the main body trunk 301, and ammonia was filled into the autoclave from the tubing 504 through the hand valve 503. The ammonia flow rate was measured, and ammonia filled into the autoclave to an ammonia volume of 50 vol% of the autoclave interior volume with liquid ammonia at -33°C. After filling with ammonia, the hand valve 503 was closed, the temperature was restored to room temperature, the tubing 504 and tubing 511 were again removed, the weight of the upper tubing-mounted autoclave was measured, and an appropriate ammonia filling volume was confirmed.

In order to grow GaN single crystals by heat treatment in an ammonia atmosphere, heating was performed with a heater from outside the autoclave, increasing the temperature over a period of 12 hours so that the temperatures of the lower level and upper level of the autoclave were at the prescribed upper level holding temperature and lower level holding temperature, and upon holding at the prescribed upper level holding temperature and lower level holding temperature shown in Table 4 below for 24 hours, the temperature was further raised to 60°C over a period of 12 hours and the autoclave was allowed to stand until reaching room temperature. The pressure in the autoclave during GaN single crystal growth was adjusted to maintain a pressure of 120 MPa at the prescribed upper level holding temperature and lower level holding temperature, while releasing the pressure with a hand valve so that it did not exceed 120 MPa.

Upon confirming that the temperature of the autoclave had reached approximately room temperature, the entire autoclave was removed from the heater, the outlet of the tubing 504 was connected to exhaust air from an ammonia recovery scrubber, and the hand valve 503 was slowly opened to discharge the ammonia in the autoclave.

In order to completely discharge the ammonia in the autoclave, high-purity nitrogen was injected 10 times into the autoclave at a pressure of 0.5 MPa, and then the venting procedure was repeated. All of the ammonia evacuation was accomplished by connection to ammonia recovery scrubber exhaust. The cover of the autoclave was then opened, and the GaN single crystal that had grown inside was confirmed.

The experimental results of Examples 12 to 15 are shown in Table 4 below.

**[Table 4]**

| | Example 12 | Example 13 | Example 14 | Example 15 |
|---|---|---|---|---|
| Upper level holding temperature | 600°C | 700°C | 740°C | 810°C |
| Lower level holding temperature | 630°C | 730°C | 780°C | 850°C |
| Repeated crystal growth frequency | 11 times | 8 times | 8 times | 3 times |

In all of Examples 12 to 15, melting had taken place in all eight GaN sheets each with a thickness of 0.4 mm, a length of 10 mm and a width of 5 mm, fabricated by HVPE with a platinum net placed at a location 40 mm above the bottom of the inside cylinder 309 of the main body trunk 301 of the autoclave in the height direction. Hexagonal columnar GaN single crystals were also confirmed to have grown on the bottom part of the inside cylinder 309 of the main body trunk 301 of the autoclave and on the inner wall surface of the platinum lining.

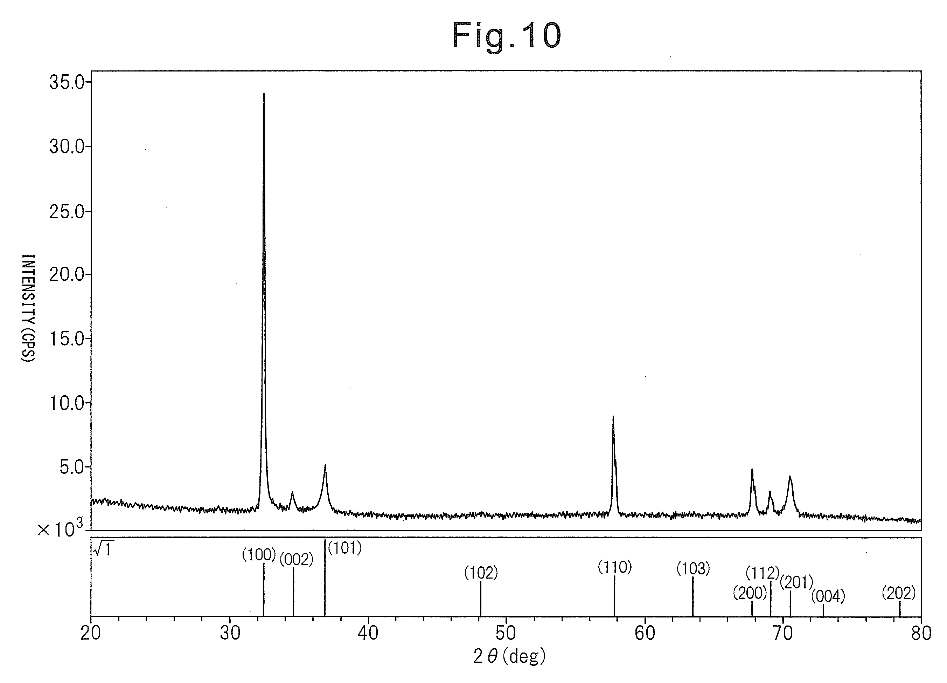

Fig. 9 is an optical microscope photograph of the GaN single crystal obtained in Example 13. In all of Examples 12 to 15, essentially hexagonal columnar GaN single crystals with lengths of no greater than about 3 mm were obtained, as shown in the optical microscope photograph of Fig. 9. Fig. 10 is a diagram showing an X-ray diffraction pattern (XRD pattern) for the GaN single crystals obtained in Example 13. The results shown in Fig. 10 confirmed high orientation of the m-face by euhedral formation of the crystal grains with the hexagonal GaN obtained in Example 13. Also, similar X-ray diffraction measurement results as those shown in Fig. 10 were obtained for Examples 12, 14 and 15.

The GaN single crystal growth experiment was repeated, and the durable frequency for repeated crystal growth with the shield section of the autoclave was measured, giving the results shown in Table 4. The durable frequency for repeated crystal growth was judged based on the number of repeated GaN crystal growth while maintaining an autoclave internal pressure of 120 MPa, without exchanging the autoclave parts.

As seen from Table 4, the shield material of the autoclave according to the invention had a significantly increased durable frequency for repeated crystal growth compared to the comparative examples described below, and improved durability for use of the autoclave, even when used in a high-temperature, high-pressure ammonia atmosphere.

### (Examples 16 to 19)

GaN single crystal growth was conducted by the same method as Examples 12 to 15, except that the shield section material used for the main body trunk shield section 302 and cone cover shield section 304 shown in Fig. 3 and Fig. 4 was an alloy of iridium and platinum with an iridium content of 40 mass%. The experimental results of Examples 16 to 19 are shown in Table 5 below.

**[Table 5]**

| | Example 16 | Example 17 | Example 18 | Example 19 |
|---|---|---|---|---|
| Upper level holding temperature | 600°C | 700°C | 740°C | 810°C |
| Lower level holding temperature | 630°C | 730°C | 780°C | 850°C |
| Repeated crystal growth frequency | 13 times | 12 times | 10 times | 5 times |

In all of Examples 16 to 19, melting had taken place with all eight GaN sheets each with a thickness of 0.4 mm, a length of 10 mm and a width of 5 mm, fabricated by HVPE with a platinum net placed at a location 40 mm above the bottom of the inside cylinder 309 of the main body trunk 301 of the autoclave in the height direction. Hexagonal columnar GaN single crystals were also confirmed to have grown on the bottom part of the inside cylinder 309 of the main body trunk 301 of the autoclave and on the inner wall surface of the platinum lining.

In all of Examples 16 to 19, essentially hexagonal columnar GaN single crystals with lengths of no greater than about 3 mm were obtained, similar to those shown in the optical microscope photograph of Fig. 9. Also, similar X-ray diffraction measurement results as those shown in Fig. 10 were obtained for Examples 16 to 19.

The GaN single crystal growth experiment was repeated, and the durable frequency for repeated crystal growth with the shield section of the autoclave was measured, giving the results shown in Table 5. The durable frequency for repeated crystal growth was judged based on the number of repeated GaN crystal growth procedures while maintaining an autoclave internal pressure of 120 MPa, without exchanging the autoclave parts.

As seen from Table 5, the shield material of the autoclave according to the invention had a significantly increased durable frequency for repeated crystal growth compared to the comparative examples described below, and improved durability for use of the autoclave, even when used in a high-temperature, high-pressure ammonia atmosphere.

### (Examples 20 to 23)

GaN single crystal growth was conducted by the same method as Examples 12 to 15, except that the shield section material used for the main body trunk shield section 302 and cone cover shield section 304 shown in Fig. 3 and Fig. 4 was an alloy of iridium and platinum with an iridium content of 60 mass%. The experimental results of Examples 20 to 23 are shown in Table 6 below.

**[Table 6]**

| | Example 20 | Example 21 | Example 22 | Example 23 |
|---|---|---|---|---|
| Upper level holding temperature | 600°C | 700°C | 740°C | 810°C |
| Lower level holding temperature | 630°C | 730°C | 780°C | 850°C |
| Repeated crystal growth frequency | 13 times | 12 times | 10 times | 7 times |

In all of Examples 20 to 23, melting had taken place with all eight GaN sheets each with a thickness of 0.4 mm, a length of 10 mm and a width of 5 mm, fabricated by HVPE with a platinum net placed at a location 40 mm above the bottom of the inside cylinder 309 of the main body trunk 301 of the autoclave in the height direction. Hexagonal columnar GaN single crystals were also confirmed to have grown on the bottom part of the inside cylinder 309 of the main body trunk 301 of the autoclave and on the inner wall surface of the platinum lining.

In all of Examples 20 to 23, essentially hexagonal columnar GaN single crystals with lengths of no greater than about 3 mm were obtained, similar to those shown in the optical microscope photograph of Fig. 9. Also, similar X-ray diffraction measurement results as those shown in Fig. 10 were obtained for Examples 20 to 23.

The GaN single crystal growth experiment was repeated, and the durable frequency for repeated crystal growth with the shield section of the autoclave was measured, giving the results shown in Table 6. The durable frequency for repeated crystal growth was judged based on the number of repeated GaN crystal growth while maintaining an autoclave internal pressure of 120 MPa, without exchanging the autoclave parts.

As seen from Table 6, the shield material of the autoclave according to the invention had a significantly increased durable frequency for repeated crystal growth compared to the comparative examples described below, and improved durability for use of the autoclave, even when used in a high-temperature, high-pressure ammonia atmosphere.

### (Examples 24 to 27)

GaN single crystal growth was conducted by the same method as Examples 12 to 15, except that the shield section material used for the main body trunk shield section 302 and cone cover shield section 304 shown in Fig. 3 and Fig. 4 was a pure iridium material with an iridium content of 100 mass%. The experimental results of Examples 24 to 27 are shown in Table 7 below.

**[Table 7]**

| | Example 24 | Example 25 | Example 26 | Example 27 |
|---|---|---|---|---|
| Upper level holding temperature | 600°C | 700°C | 740°C | 810°C |
| Lower level holding temperature | 630°C | 730°C | 780°C | 850°C |
| Repeated crystal growth frequency | 15 times | 13 times | 11 times | 9 times |

In all of Examples 24 to 27, melting had taken place with all eight GaN sheets each with a thickness of 0.4 mm, a length of 10 mm and a width of 5 mm, fabricated by HVPE with a platinum net placed at a location 40 mm above the bottom of the inside cylinder 309 of the main body trunk 301 of the autoclave in the height direction. Hexagonal columnar GaN single crystals were also confirmed to have grown on the bottom part of the inside cylinder 309 of the main body trunk 301 of the autoclave and on the inner wall surface of the platinum lining.

In all of Examples 24 to 27, essentially hexagonal columnar GaN single crystals with lengths of no greater than about 3 mm were obtained, similar to those shown in the optical microscope photograph of Fig. 9. Also, similar X-ray diffraction measurement results as those shown in Fig. 10 were obtained for Examples 24 to 27.

The GaN single crystal growth experiment was repeated, and the durable frequency for repeated crystal growth with the shield section of the autoclave was measured, giving the results shown in Table 7. The durable frequency for repeated crystal growth was judged based on the number of repeated GaN crystal growth while maintaining an autoclave internal pressure of 120 MPa, without exchanging the autoclave parts.

As seen from Table 7, the shield material of the autoclave according to the invention had a significantly increased durable frequency for repeated crystal growth compared to the comparative examples described below, and improved durability for use of the autoclave, even when used in a high-temperature, high-pressure ammonia atmosphere.

### (Comparative Examples 12 to 15)

GaN single crystal growth was conducted by the same method as Examples 12 to 15, except that the shield section material used for the main body trunk shield section 302 and cone cover shield section 304 shown in Fig. 3 and Fig. 4 was a pure platinum material with an platinum content of 100 mass%. The experimental results for Comparative Examples 12 to 15 are shown in Table 8 below.

**[Table 8]**

| | Comp. Ex. 12 | Comp. Ex. 13 | Comp. Ex. 14 | Comp. Ex. 15 |
|---|---|---|---|---|
| Upper level holding temperature | 600°C | 700°C | 740°C | 810°C |
| Lower level holding temperature | 630°C | 730°C | 780°C | 850°C |
| Repeated crystal growth frequency | 1 time | 1 time | 1 time | 1 time |

In all of Comparative Examples 12 to 15, melting had taken place in all eight GaN sheets each with a thickness of 0.4 mm, a length of 10 mm and a width of 5 mm, fabricated by HVPE with a platinum net placed at a location 40 mm above the bottom of the inside cylinder 309 of the main body trunk 301 of the autoclave in the height direction. Hexagonal columnar GaN single crystals were also confirmed to have grown on the bottom part of the inside cylinder 309 of the main body trunk 301 of the autoclave and on the inner wall surface of the platinum lining.

In all of Comparative Examples 12 to 15, essentially hexagonal columnar GaN single crystals with lengths of no greater than about 3 mm were obtained, similar to those shown in the optical microscope photograph of Fig. 9. Also, similar X-ray diffraction measurement results as those shown in Fig. 10 were obtained for Comparative Examples 12 to 15. In all of Comparative Examples 12 to 15, therefore, it was confirmed that GaN single crystals had been obtained, similar to Examples 12 to 27.

The GaN single crystal growth experiment was repeated, and the durable frequency for repeated crystal growth with the shield section of the autoclave was measured, giving the results shown in Table 8. The durable frequency for repeated crystal growth was judged based on the number of repeated GaN crystal growth procedures while maintaining an autoclave internal pressure of 120 MPa, without exchanging the autoclave parts.

As seen from Table 8, the shield materials of the autoclaves in Comparative Examples 12 to 15 had a durable frequency for repeated crystal growth of only one time when used in a high-temperature, high-pressure ammonia atmosphere, and repeated use was therefore impossible. In all of Comparative Examples 12 to 15, wear and detachment of the shield section was seen with only one GaN single crystal growth procedure. The detachment was attributed to fusion. The degree of detachment was more severe in Comparative Example 15 than in Comparative Example 12, indicating that the degree of detachment increases with higher operating temperature. In all of Comparative Examples 12 to 15, detachment was confirmed in the cone cover shield section, and wear was confirmed in the main body trunk shield section.

### Industrial Applicability

According to the method for producing a nitride single crystal and the autoclave according to the invention, it is possible to accomplish growth of a nitride single crystal at a rate of 30 µm/day or greater, which is a faster rate than the prior art. In addition, a nitride single crystal obtained by the method for producing a nitride single crystal and the autoclave according to the invention can have a flat membrane-like growth layer. Thus, according to the invention it is possible to obtain a bulk nitride single crystal that allows cutting out of substrates with various crystal orientations. Also according to the invention, it is possible to accomplish production of high quality single crystal grains with sizes of 1 mm or greater that can also be used as seed crystals, that have not been obtainable by conventional ammonothermal methods, at industrially practical temperatures and pressures. A single crystal obtained according to the invention can be suitably applied for luminescent devices such as light emitting diodes and laser diodes.

### Explanation of Symbols

101, 201 Pressure gauges
102, 202 Valves
103, 203 Main bodies
104, 204 Conduits
105, 205 Starting material containers
106, 206 Starting materials
107 Seed crystal
108, 208 Heaters
109, 209 Starting material feeder sites
110, 210 Single crystal growth sites
111, 211 Interior bottoms
207 Plate
301 Main body trunk
302 Main body trunk shield section
303 Cone cover
304 Cone cover shield section
305 Outside cover
306 Buffer packing material
307 Screw section
308A, 308B Thermocouple
309 Inside cylinder
310 Conduit
501, 506 Three-way connecting joints
502, 504, 505, 507, 509, 511 Tubings
503 Hand valve
508 Pressure sensor
510 Automatic valve

## Claims

1. A method for producing a Ga-containing nitride single crystal by an ammonothermal method from a starting material containing at least one material selected from the group consisting of Ga-containing nitride polycrystals, Ga-containing nitrides and Ga-containing nitride precursors, the method comprising:
introducing at least the starting material, one or more acidic mineralizers and ammonia into an autoclave, and then growing a Ga-containing nitride single crystal under conditions satisfying the following (a) to (e):
(a) the autoclave includes a starting material feeder site in which the starting material is placed and a single crystal growth site for growth of the Ga-containing nitride single crystal,
(b) the single crystal growth site is the site in which a seed crystal is placed,
(c) the temperature (T1) at the single crystal growth site is 600°C to 850°C,
(d) the temperature (T1) at the single crystal growth site and the temperature (T2) at the starting material feeder site are in the relationship T1 > T2, and
(e) the pressure in the autoclave is 40 MPa to 250 MPa.

2. A method for producing a Ga-containing nitride single crystal by an ammonothermal method from a starting material containing at least one material selected from the group consisting of Ga-containing nitride polycrystals, Ga-containing nitrides and Ga-containing nitride precursors, the method comprising:
introducing at least the starting material, one or more acidic mineralizers and ammonia into an autoclave, and then growing a Ga-containing nitride single crystal under conditions satisfying the following (a) to (e):
(a) the autoclave includes a starting material feeder site in which the starting material is placed and a single crystal growth site for growth of the Ga-containing nitride single crystal,
(b) the single crystal growth site is the site in which a Ga-containing nitride single crystal deposits and grows by spontaneous nucleation,
(c) the temperature (T1) at the single crystal growth site is 600°C to 850°C,
(d) the temperature (T1) at the single crystal growth site and the temperature (T2) at the starting material feeder site are in the relationship T1 > T2, and
(e) the pressure in the autoclave is 40 MPa to 250 MPa.

3. The method for producing a nitride single crystal according to claim 1, wherein the seed crystal is a Ga-containing nitride single crystal produced by the method for producing a nitride single crystal according to claim 2.

4. The method for producing a nitride single crystal according to any one of claims 1 to 3, wherein:
the starting material is placed in a container having a plurality of holes or slit-like gaps formed therein, and
gaps of 1 mm or greater are present between the sides of the container and the inner wall of the autoclave.

5. The method for producing a nitride single crystal according to any one of claims 1 to 4, wherein the autoclave is a vertical autoclave, and the starting material feeder site is at a higher position than the single crystal growth site.

6. The method for producing a nitride single crystal according to claim 5, wherein:
the starting material feeder site is at a position at a height of at least 10 mm from the interior bottom of the autoclave, and
the single crystal growth site is present between the starting material feeder site and the interior bottom of the autoclave.

7. The method for producing a nitride single crystal according to any one of claims 1 to 6, wherein at least one partition plate is placed between the starting material feeder site and the single crystal growth site.

8. The method for producing a nitride single crystal according to any one of claims 2 and 4 to 7, wherein:
the single crystal growth site is the site where a Ga-containing nitride single crystal deposits and grows by spontaneous nucleation, and
a corrosion-resistant plate with at least one hole is placed in the single crystal growth site.

9. The method for producing a nitride single crystal according to any one of claims 1 to 8, wherein the starting material contains Ga-containing nitride polycrystals produced by a gas phase method.

10. A substrate made of a nitride single crystal produced by the method for producing a nitride single crystal according to any one of claims 1 to 9.

11. A nitride single crystal produced by the method for producing a nitride single crystal according to any one of claims 1 to 9 and having a maximum dimension of 1 mm or greater.

12. An autoclave to be used for a method for producing a nitride single crystal according to any one of claims 1 to 9, wherein:
the material of the shield section, which is the section that bonds two or more parts composing the autoclave to maintain the pressure in the autoclave, is made of an alloy of iridium and platinum or iridium alone, and
the proportion of iridium among the entire constituent elements of the material of the shield section is 20 mass% to 100 mass%.
